# EUROPEAN PATENT APPLICATION

(11) **EP 2 475 234 A2**
(43) Date of publication of application: **11.07.2012**
(21) Application number: 12162284.9
(22) Date of filing: 13.04.2010
(51) Int. Cl.: H05K 3/24

(54) **Substrate for printed wiring board, printed wiring board, and methods for producing same**

(30) Priority: 24.04.2009 JP 2009106948; 23.10.2009 JP 2009244273; 10.03.2010 JP 2010052569; 10.03.2010 JP 2010052570
(62) Divisional of application: 10766975.6
(71) Applicant: Sumitomo Electric Industries, Ltd., Osaka-shi, Osaka 541 (JP)
(72) Inventor: Oka, Yoshio, Osaka-shi, Osaka 554-0024 (JP); Kasuga, Takashi, Osaka-shi, Osaka 554-0024 (JP); Okada, Issei, Osaka-shi, Osaka 554-0024 (JP); Mikage, Katsunari, Osaka-shi, Osaka 554-0024 (JP); Uenishi, Naota, Osaka-shi, Osaka 554-0024 (JP); Okuda, Yasuhiro, Osaka-shi, Osaka 554-0024 (JP)
(74) Representative: Setna, Rohan P.

(57) **Abstract**

A substrate for a printed wiring board, comprising an insulating base and a conductive layer covering a surface of the base, wherein the base has a through-hole penetrating the base, and the conductive layer is composed of a conductive ink layer that covers the entire inner surface of the through-hole and an upper surface and a lower surface of the base and that contains metal particles.

## Description

### Technical Field

The present invention relates to a substrate for a printed wiring board, a printed wiring board, and methods for producing the same.

### Background Art

Hitherto, a substrate of a printed wiring board, i.e., a substrate for a printed wiring board has been generally produced by a method in which a heat-resistant polymer film is bonded to a copper foil with an organic adhesive therebetween, or a method in which a heat-resistant polymer film is stacked on a copper foil by, for example, coating a surface of the copper foil with a resin solution and drying the resin solution.
Furthermore, recently, the realization of high density and high performance of printed wiring boards has been increasingly required.
As a substrate for a printed wiring board that satisfies such requirements for the realization of high density and high performance, a substrate for a printed wiring board that does not include an organic adhesive layer and that includes a conductive layer (copper foil layer) having a sufficiently small thickness has been desired.
In response to the above-described requirements for the substrate for a printed wiring board, for example, Japanese Unexamined Patent Application Publication No. 9-136378 discloses a copper thin-film substrate in which a copper thin layer is stacked on a heat-resistant polymer film without interposing an adhesive therebetween. In this copper thin film substrate, a copper thin-film layer is formed as a first layer on a surface of a heat-resistant insulating base by a sputtering method, and a copper thick-film layer is formed as a second layer on the first layer by an electroplating method.
Meanwhile, in producing a double-sided printed wiring board, after a through-hole is formed, a desmear process is performed, electroless plating and electrolytic plating are performed, and a resist formation and etching are performed.
As a substrate for a printed wiring board that satisfies requirements for the realization of high density and high performance of a printed wiring board, a substrate for a printed wiring board that does not include an organic adhesive layer and that includes a conductive layer (copper foil layer) having a sufficiently small thickness has been desired.
In addition, Japanese Unexamined Patent Application Publication No. 6-120640 discloses a method for producing a flexible printed wiring board on which components can be mounted with high density.

### Citation List

### Patent Literature

PTL 1: Japanese Unexamined Patent Application Publication No. 9-136378
PTL 2: Japanese Unexamined Patent Application Publication No. 6-120640

### Summary of Invention

### Technical Problem

The copper thin-film substrate described in PTL 1 is a substrate that meets the requirements for high-density, high-performance printed wiring from the standpoint that, for example, no organic adhesive is used, and the thickness of the conductive layer (copper foil layer) can be reduced.
On the other hand, since the first layer is formed by a sputtering method, vacuum equipment is necessary, and the equipment-related costs, namely, the costs of manufacture, maintenance, and operation of the equipment are high. In addition, all operations such as the supply of the base used, the formation of a thin film, and the storage of the base must be performed in a vacuum. Furthermore, in terms of equipment, there is a problem in that the degree to which the substrate can be increased in size is limited.
The method for producing a flexible printed wiring board described in PTL 2 provides a printed wiring board that meets the requirements for high-density, high-performance printed wiring from the standpoint that the distance between terminals can be reduced.
On the other hand, the thickness of a wiring circuit is the sum of the thickness of an original copper-clad laminate and the thickness of a plating layer. Accordingly, this method has a problem in that the wiring circuit has a large thickness, and thus it is difficult to prepare a high-density, high-performance wiring circuit.

An object of the present invention is to resolve the above problems in the related art and to provide a substrate for a printed wiring board, and a printed wiring board, which are not limited in size because vacuum equipment is not necessary for the production, in which an organic adhesive is not used, and which can include a conductive layer (copper foil layer) having a sufficiently small thickness; and a method for producing the substrate for a printed wiring board.
Another object of the present invention is to provide a substrate for a printed wiring board, and a printed wiring board, which can realize high density, high performance, and a sufficiently small thickness using various types of bases that have no limitations in terms of properties, and a method for producing the printed wiring board.
Another object of the present invention is to provide a substrate for a printed wiring board, in which the growth of an oxide at the interface between an insulating base and a conductive layer can be suppressed in an oxidizing atmosphere (in particular, an oxidizing atmosphere at a high temperature), thereby preventing separation of the insulating base and a plating layer, and which has good etching properties, and a method for producing the same.

### Solution to Problem

According to a first aspect of a substrate for a printed wiring board of the present invention, the substrate being capable of solving the above problems, the substrate for a printed wiring board includes an insulating base; a first conductive layer stacked on the insulating base; and a second conductive layer stacked on the first conductive layer, wherein the first conductive layer is a coating layer composed of a conductive ink containing metal particles, and the second conductive layer is a plating layer.
According to a second aspect of the substrate for a printed wiring board of the present invention, in addition to the first aspect, a void portion of the first conductive layer formed of the coating layer composed of the conductive ink is filled with an electroless metal plating portion.
According to a third aspect of the substrate for a printed wiring board of the present invention, in addition to the first or second aspect, the first conductive layer is a coating layer composed of a conductive ink containing metal particles having a particle diameter of 1 to 500 nm.
According to a fourth aspect of the substrate for a printed wiring board of the present invention, in addition to any one of the first aspect to the third aspect, the metal particles are particles obtained by a liquid-phase reduction method in which metal ions are reduced by an action of a reducing agent in an aqueous solution containing a complexing agent and a dispersant.
According to a fifth aspect of the substrate for a printed wiring board of the present invention, in addition to any one of the first aspect to the fourth aspect, the metal particles are particles obtained by a titanium redox method.
According to a sixth aspect of the substrate for a printed wiring board of the present invention, in addition to any one of the first aspect to the fifth aspect, an interlayer composed of at least one element selected from Ni, Cr, Ti, and Si is present between the insulating base and the first conductive layer.
According to a seventh aspect of a printed wiring board of the present invention, the printed wiring board being capable of solving the above problems, the printed wiring board is produced by using the substrate for a printed wiring board according to any one of the first aspect to the sixth aspect.
According to an eighth aspect of the printed wiring board of the present invention, in the printed wiring board of the seventh aspect, the printed wiring board is a multilayer board including an insulating base and conductive layers facing each other with the insulating base therebetween, at least one of the conductive layers includes a first conductive layer and a second conductive layer, the first conductive layer is a coating layer composed of a conductive ink, and the second conductive layer is a plating layer provided on the first conductive layer.
According to a ninth aspect of the printed wiring board of the present invention, in addition to the seventh or eighth aspect, the second conductive layer is formed as a pattern on the first conductive layer functioning as an underlayer by a semi-additive process using a resist.
According to a tenth aspect of a method for producing a substrate for a printed wiring board of the present invention, the method being capable of solving the above problems, the method includes a step of forming a first conductive layer by applying, onto an insulating base formed of a film or a sheet, a conductive ink in which metal particles having a particle diameter of 1 to 500 nm are dispersed, and performing heat treatment, whereby the metal particles in the applied conductive ink are fixed as a metal layer onto the insulating base; and a step of forming a second conductive layer by stacking a metal layer on the first conductive layer by plating.
According to an eleventh aspect of the method for producing a substrate for a printed wiring board of the present invention, in addition to the tenth aspect, the method further includes a step of electroless metal plating for filling a void portion of the first conductive layer, the step of electroless metal plating being performed before the step of forming the second conductive layer.
According to a twelfth aspect of the method for producing a substrate for a printed wiring board of the present invention, in addition to the tenth or eleventh aspect, the metal particles are particles obtained by a liquid-phase reduction method in which metal ions are reduced by an action of a reducing agent in an aqueous solution containing a complexing agent and a dispersant.
According to a thirteenth aspect of the method for producing a substrate for a printed wiring board of the present invention, in addition to any one of the tenth aspect to the twelfth aspect, the metal particles are particles obtained by a titanium redox method.
According to a fourteenth aspect of the method for producing a substrate for a printed wiring board of the present invention, in addition to any one of the tenth aspect to the thirteenth aspect, the heat treatment of the conductive ink is performed at a temperature of 150°C to 500°C in a non-oxidizing atmosphere or a reducing atmosphere.
According to a fifteenth aspect of a substrate for a printed wiring board of the present invention, the substrate for a printed wiring board includes an insulating base and a conductive layer covering a surface of the base, wherein the base has a through-hole penetrating the base, and the conductive layer is composed of a conductive ink layer that covers the entire inner surface of the through-hole and an upper surface and a lower surface of the base and that contains metal particles.
According to a sixteenth aspect of the substrate for a printed wiring board of the present invention, in addition to the fifteenth aspect, the conductive layer includes a first conductive layer composed of a conductive ink layer that covers the entire inner surface of the through-hole and the upper surface and the lower surface of the base and that contains metal particles, and a second conductive layer composed of a plating layer stacked on the first conductive layer.
According to a seventeenth aspect of the substrate for a printed wiring board of the present invention, in addition to the sixteenth aspect, the plating layer is formed by electroless plating and/or electrolytic plating.
According to an eighteenth aspect of the substrate for a printed wiring board of the present invention, in addition to any one of the fifteenth aspect to the seventeenth aspect, the conductive ink layer is composed of a conductive ink containing metal particles having a particle diameter of 1 to 500 nm.
According to a nineteenth aspect of the substrate for a printed wiring board of the present invention, in addition to any one of the fifteenth aspect to the eighteenth aspect, the metal particles are particles obtained by a liquid-phase reduction method in which metal ions are reduced by an action of a reducing agent in an aqueous solution containing a complexing agent and a dispersant.
According to a twentieth aspect of the substrate for a printed wiring board of the present invention, in addition to any one of the fifteenth aspect to the nineteenth aspect, the metal particles are particles obtained by a titanium redox method.
According to a twenty-first aspect of the substrate for a printed wiring board of the present invention, in addition to any one of the fifteenth aspect to the twentieth aspect, an interlayer composed of at least one element selected from Ni, Cr, Ti, and Si is present between the insulating base and the first conductive layer.
According to a twenty-second aspect of a printed wiring board of the present invention, the printed wiring board is produced by using the substrate for a printed wiring board according to any one of the fifteenth aspect to the twenty-first aspect.
According to a twenty-third aspect of the printed wiring board of the present invention, in addition to the twenty-second aspect, the second conductive layer is formed as a pattern on the first conductive layer functioning as an underlayer by a semi-additive process using a resist.
According to a twenty-fourth aspect of a method for producing a printed wiring board of the present invention, the method includes at least a through-hole-forming step of forming a through-hole in an insulating base; a conductive ink-applying step of applying a conductive ink containing metal particles dispersed in a solvent onto the insulating base having the through-hole, the conductive ink-applying step being performed after the through-hole-forming step; and a heat-treatment step of performing heat treatment after the conductive ink-applying step.
According to a twenty-fifth aspect of the method for producing a printed wiring board of the present invention, in addition to the twenty-fourth aspect, the method further includes at least an electrolytic plating step of performing electrolytic copper plating after the heat-treatment step; a resist pattern-forming step of forming a resist pattern after the electrolytic plating step; and an etching step of performing etching after the resist pattern-forming step.
According to a twenty-sixth aspect of the method for producing a printed wiring board of the present invention, in addition to the twenty-fifth aspect, the method further includes an electroless plating step of performing electroless plating before the electrolytic plating step.
According to a twenty-seventh aspect of a method for producing a printed wiring board of the present invention, the method includes at least a through-hole-forming step of forming a through-hole in an insulating base; a conductive ink-applying step of applying a conductive ink containing metal particles dispersed in a solvent onto the insulating base having the through-hole, the conductive ink-applying step being performed after the through-hole-forming step; a heat-treatment step of performing heat treatment after the conductive ink-applying step; a resist pattern-forming step of forming a resist pattern after the heat-treatment step; an electrolytic plating step of performing electrolytic copper plating after the resist pattern-forming step; a resist pattern-removing step of removing the resist pattern formed in the resist pattern-forming step, the resist pattern-removing step being performed after the electrolytic plating step; and a conductive ink layer-removing step of removing a conductive ink layer exposed in the resist pattern-removing step, the conductive ink layer-removing step being performed after the resist pattern-removing step.
According to a twenty-eighth aspect of the method for producing a printed wiring board of the present invention, in addition to the twenty-seventh aspect, the method further includes an electroless plating step of performing electroless plating before the resist pattern-forming step.
According to a twenty-ninth aspect of a substrate for a printed wiring board of the present invention, the substrate for a printed wiring board includes an insulating base and copper stacked on a surface of the insulating base, wherein metal particles that suppress oxidation of a copper layer are dispersed and made to adhere to an interface between the insulating base and the copper.
According to a thirtieth aspect of the substrate for a printed wiring board of the present invention, in addition to the twenty-ninth aspect, the metal particles include at least Ni particles.
According to a thirty-first aspect of the substrate for a printed wiring board of the present invention, in addition to the twenty-ninth aspect, the metal particles include Ni particles and Cu particles.
According to a thirty-second aspect of a method for producing a substrate for a printed wiring board of the present invention, the method includes at least a conductive ink-applying step of applying a conductive ink containing metal particles onto a surface of an insulating base; a heat-treatment step of performing heat treatment after the conductive ink-applying step; and an electrolytic plating step of performing electrolytic copper plating after the heat-treatment step.

According to the substrate for a printed wiring board according to the first aspect, a conductive layer stacked on an insulating base is composed of a combination of a first conductive layer which is as a coating layer composed of a conductive ink containing metal particles, and a second conductive layer which is a plating layer stacked on the first conductive layer. Accordingly, expensive vacuum equipment, which is necessary for physical vapor deposition such as sputtering, is not necessary. Thus, the size of the substrate for a printed wiring board is not limited by vacuum equipment.
Furthermore, the conductive layer can be formed on the base without using an organic adhesive.
Furthermore, since the first conductive layer, which is used in combination as an underlayer of the second conductive layer, is a coating layer containing metal particles, it is possible to provide a substrate for a printed wiring board using various types of bases that have no limitations in terms of material.
Furthermore, it is possible to provide a substrate that is suitable for forming high-density, high-performance printed wiring including a sufficiently thin conductive layer, the substrate being provided with a conductive layer including a sufficiently thin first conductive layer which is a coating layer and a second conductive layer whose thickness is adjusted to be a necessary value by plating.

According to the substrate for a printed wiring board according to the second aspect, in addition to the operation and effect achieved by the first aspect, a void portion of the first conductive layer formed of the coating layer composed of the conductive ink is filled with an electroless metal plating portion, and thus the first conductive layer formed of the conductive ink becomes dense. Since the first conductive layer becomes dense, the number of break starting points inside the first conductive layer decreases, and thus separation of the first conductive layer can be more reliably prevented. In addition, the number of such non-conductive void portions can be decreased by forming the electroless metal plating portion, and thus the subsequent formation of the second conductive layer can also be satisfactorily performed by an electroplating method without increasing the coating thickness of the first conductive layer. In addition, since the first conductive layer need not have a large coating thickness, the number of break starting points inside the first conductive layer can be decreased accordingly. The cost can also be reduced.
According to the substrate for a printed wiring board according to the third aspect, in addition to the operation and effect achieved by the first aspect or the second aspect, the first conductive layer is a coating layer composed of a conductive ink containing metal particles having a particle diameter of 1 to 500 nm, and thus a dense, uniform, and thin layer can be evenly and stably formed on an insulating base. Consequently, the plating layer which is the second conductive layer can also be formed as a dense and uniform layer. Accordingly, it is possible to provide a substrate for a printed wiring board, the substrate including a thin and defect-free conductive layer suitable for obtaining fine printed wiring.
According to the substrate for a printed wiring board according to the fourth aspect, in addition to the operation and effect achieved by any one of the first aspect to the third aspect, the metal particles are particles obtained by a liquid-phase reduction method in which metal ions are reduced by an action of a reducing agent in an aqueous solution containing a complexing agent and a dispersant, and thus a device used for obtaining the particles is relatively simpler than a device used in a gas-phase method, resulting in a reduction in the cost. In addition, the particles can be easily mass-produced, and are easily available. Furthermore, the liquid-phase reduction method is advantageous in that the particle diameter can be controlled to be relatively uniform by, for example, performing stirring in the aqueous solution.
According to the substrate for a printed wiring board according to the fifth aspect, in addition to the operation and effect achieved by any one of the first aspect to the fourth aspect, the metal particles are particles obtained by a titanium redox method, and thus the particle diameter can be reliably and easily controlled to be 1 to 500 nm, and the resulting first conductive layer can be formed as a dense, uniform, and sufficiently thin underlayer having few defects in the form of particles having a spherical shape and having a uniform size. Accordingly, the plating layer which is the second conductive layer can also be formed as a dense and uniform layer. It is possible to obtain a defect-free conductive layer having a sufficiently small thickness as a whole and suitable for forming fine printed wiring.
According to the substrate for a printed wiring board according to the sixth aspect, in addition to the operation and effect achieved by any one of the first aspect to the fifth aspect, an interlayer composed of at least one element selected from Ni, Cr, Ti, and Si is present between the insulating base and the first conductive layer, and thus the interlayer functions as an underlayer when the first conductive layer is stacked on the insulating base, thereby improving the adhesiveness.

According to the printed wiring board according to the seventh aspect, the printed wiring board is produced by using the substrate for a printed wiring board according to any one of the first aspect to the sixth aspect, and thus it is possible to satisfy requirements for high-density, high-performance printed wiring including a conductive layer having a reduced thickness.
According to the eighth aspect, in the printed wiring board according to the seventh aspect, the printed wiring board is a multilayer board including an insulating base and conductive layers facing each other with the insulating base therebetween, at least one of the conductive layers includes a first conductive layer and a second conductive layer, the first conductive layer is a coating layer composed of a conductive ink, and the second conductive layer is a plating layer provided on the first conductive layer. Therefore, it is possible to provide a printed wiring board in which printed wiring layers including the first conductive layer and the second conductive layer are easily formed in each different pattern. In this case, a high-density, high-performance printed wiring layer composed of a thin layer can be obtained without requiring expensive vacuum equipment.
According to the printed wiring board according to the ninth aspect, in addition to the operation and effect achieved by the seventh aspect or the eighth aspect, the second conductive layer is formed as a pattern on the first conductive layer functioning as an underlayer by a semi-additive process using a resist, and thus a higher-density printed wiring board can be provided.

According to the method for producing a substrate for a printed wiring board according to the tenth aspect, the production is performed by application of a conductive ink, heat treatment, and plating, and thus a substrate for a printed wiring board can be produced without requiring expensive vacuum equipment and without using an organic adhesive. In the step of forming a first conductive layer, a method of applying a conductive ink in which metal particles are dispersed is used, and thus this method is advantageous in that various types of bases can be used without limitations in terms of material. In addition, by performing the heat treatment, it is possible to remove unnecessary organic substances and the like contained in the ink and to reliably fix the metal particles onto the insulating base. By using metal particles on the order of nanometers, a sufficiently dense and uniform first conductive layer can be obtained, and the second conductive layer can be formed by plating thereon. Thus, a defect-free, dense, and homogeneous substrate can be produced. Since the second conductive layer is stacked by plating, the thickness of the second conductive layer can be accurately adjusted, and the thickness can be adjusted to a predetermined thickness within a relatively short time. Accordingly, as described above, it is possible to produce a substrate suitable for forming high-density, high-performance printed wiring including a sufficiently thin conductive layer.

According to the method for producing a substrate for a printed wiring board according to the eleventh aspect, in addition to the operation and effect achieved by the tenth aspect, a step of electroless metal plating for filling a void portion of the first conductive layer is performed before the step of forming the second conductive layer, whereby the first conductive layer formed of a conductive ink can be made denser, and thus the number of break starting points inside the first conductive layer can be decreased, thus reliably preventing separation of the first conductive layer. In addition, by performing the electroless metal plating, even when the coating thickness of the first conductive layer itself is decreased, the number of void portions can be decreased. Consequently, the subsequent formation of the second conductive layer can be satisfactorily performed even by using an electroplating method. In addition, since the first conductive layer need not have a large coating thickness, the number of break starting points inside the first conductive layer can be decreased accordingly. The cost can also be reduced.
According to the method for producing a substrate for a printed wiring board according to the twelfth aspect, in addition to the operation and effect achieved by the tenth aspect or the eleventh aspect, the metal particles are particles obtained by a liquid-phase reduction method in which metal ions are reduced by an action of a reducing agent in an aqueous solution containing a complexing agent and a dispersant, and thus a device used for obtaining the particles is relatively simpler than a device used in a gas-phase method, resulting in a reduction in the cost. In addition, the particles can be easily mass-produced, and are easily available. Furthermore, a satisfactory substrate for a printed wiring board can be provided using particles having a relatively uniform particle diameter, the particles being obtained by, for example, performing stirring in the aqueous solution.

According to the method for producing a substrate for a printed wiring board according to the thirteenth aspect, in addition to the operation and effect achieved by any one of the tenth aspect to the twelfth aspect, the metal particles are particles obtained by a titanium redox method, and thus the particle diameter can be reliably and easily controlled to be 1 to 500 nm, and the resulting first conductive layer can be formed as a dense, uniform, and sufficiently thin underlayer having few defects in the form of particles having a spherical shape and having a uniform size. Accordingly, the plating layer which is the second conductive layer can also be formed as a dense and uniform layer. It is possible to produce a defect-free substrate for a printed wiring board, the substrate including a layer having a sufficiently small thickness as a whole.
According to the method for producing a substrate for a printed wiring board according to the fourteenth aspect, in addition to the operation and effect achieved by any one of the tenth aspect to the thirteenth aspect, the heat treatment of the conductive ink is performed at a temperature of 150°C to 500°C in a non-oxidizing atmosphere or a reducing atmosphere, whereby the metal particles in the applied conductive ink can be reliably fixed to the surface of the underlayer without being oxidized.

According to the substrate for a printed wiring board according to the fifteenth aspect of the present invention, a substrate for a printed wiring board includes an insulating base and a conductive layer covering a surface of the base, in which the base has a through-hole penetrating the base, and the conductive layer is composed of a conductive ink layer that covers the entire inner surface of the through-hole and an upper surface and a lower surface of the base and that contains metal particles. Accordingly, expensive vacuum equipment, which is necessary for physical vapor deposition such as sputtering, is not necessary. Thus, the size of the substrate for a printed wiring board (mainly for a double-sided printed wiring board) is not limited by vacuum equipment.
Furthermore, the conductive layer can be formed on the base without using an organic adhesive.
Furthermore, since the conductive layer is a layer containing metal particles, it is possible to provide a substrate for a printed wiring board using various types of bases that have no limitations in terms of material.
Furthermore, by forming a conductive layer formed of a conductive ink layer containing metal particles, it is possible to provide a substrate for a printed wiring board, the substrate being suitable for forming high-density, high-performance printed wiring including a sufficiently thin conductive layer.

According to the substrate for a printed wiring board according to the sixteenth aspect of the present invention, in addition to the operation and effect achieved by the fifteenth aspect of the present invention, the conductive layer includes a first conductive layer composed of a conductive ink layer that covers the entire inner surface of the through-hole and the upper surface and the lower surface of the base and that contains metal particles, and a second conductive layer composed of a plating layer stacked on the first conductive layer. Thus, it is possible to provide a substrate for a printed wiring board, the substrate being suitable for forming high-density, high-performance printed wiring including a sufficiently thin conductive layer, and being provided with a conductive layer including a sufficiently thin first conductive layer and a second conductive layer whose thickness is adjusted to be a necessary value by plating.

According to the substrate for a printed wiring board according to the seventeenth aspect of the present invention, in addition to the operation and effect achieved by the sixteenth aspect of the present invention, the plating layer is formed by electroless plating and/or electrolytic plating. Accordingly, in the case where the plating layer is formed by only electroless plating, application of a current is not necessary, and a plating layer having a uniform thickness can be formed regardless of the shape and the type of material.
In the case where the plating layer is formed by only electrolytic plating, the plating layer can be rapidly formed up to a predetermined stack thickness. Furthermore, the plating layer can be stacked while accurately adjusting the thickness thereof, and the resulting plating layer can be formed as a defect-free, homogeneous layer.
In the case where the plating layer is formed by electroless plating and electrolytic plating, the thickness of the first conductive layer composed of a conductive ink layer containing metal particles can be made small. Consequently, it is possible to provide a substrate for a printed wiring board in which the amount of ink can be saved and thus the cost can be reduced.

According to the substrate for a printed wiring board according to the eighteenth aspect of the present invention, in addition to the operation and effect achieved by any one of the fifteenth aspect to the seventeenth aspect of the present invention, the conductive ink layer is composed of a conductive ink containing metal particles having a particle diameter of 1 to 500 nm, and thus a dense, uniform, and thin layer can be evenly and stably formed on an insulating base. Accordingly, it is possible to provide a substrate for a printed wiring board, the substrate including a thin and defect-free conductive layer suitable for obtaining fine printed wiring.

According to the substrate for a printed wiring board according to the nineteenth aspect of the present invention, in addition to the operation and effect achieved by any one of the fifteenth aspect to the eighteenth aspect of the present invention, the metal particles are particles obtained by a liquid-phase reduction method in which metal ions are reduced by an action of a reducing agent in an aqueous solution containing a complexing agent and a dispersant, and thus a device used for obtaining the particles is relatively simpler than a device used in a gas-phase method, resulting in a reduction in the cost. In addition, the particles can be easily mass-produced, and are easily available. Furthermore, the liquid-phase reduction method is advantageous in that the particle diameter can be controlled to be relatively uniform by, for example, performing stirring in the aqueous solution.

According to the substrate for a printed wiring board according to the twentieth aspect of the present invention, in addition to the operation and effect achieved by any one of the fifteenth aspect to the nineteenth aspect of the present invention, the metal particles are particles obtained by a titanium redox method, and thus the particle diameter can be reliably and easily controlled to be 1 to 500 nm, and the resulting conductive ink layer can be formed as a dense, uniform, and sufficiently thin layer having few defects in the form of particles having a spherical shape and having a uniform size. Accordingly, a conductive layer suitable for forming fine printed wiring can be obtained.

According to the substrate for a printed wiring board according to the twenty-first aspect of the present invention, in addition to the operation and effect achieved by any one of the fifteenth aspect to the twentieth aspect of the present invention, an interlayer composed of at least one element selected from Ni, Cr, Ti, and Si is present between the insulating base and the conductive ink layer, and thus the interlayer functions as an underlayer when the conductive ink layer is stacked on the insulating base, thereby improving the adhesiveness.

According to the printed wiring board according to the twenty-second aspect of the present invention, the printed wiring board is produced by using the substrate for a printed wiring board according to any one of the fifteenth aspect to the twenty-first aspect of the present invention, and thus it is possible to satisfy requirements for high-density, high-performance printed wiring which includes a conductive layer having a reduced thickness, and for which expensive vacuum equipment is not necessary.

According to the printed wiring board according to the twenty-third aspect of the present invention, in addition to the operation and effect achieved by the twenty-second aspect of the present invention, the second conductive layer is formed as a pattern on the first conductive layer functioning as an underlayer by a semi-additive process using a resist, and thus a higher-density printed wiring board can be provided.

According to the method for producing a printed wiring board according to the twenty-fourth aspect of the present invention, the method includes at least a through-hole-forming step of forming a through-hole in an insulating base; a conductive ink-applying step of applying a conductive ink containing metal particles dispersed in a solvent onto the insulating base having the through-hole, the conductive ink-applying step being performed after the through-hole-forming step; and a heat-treatment step of performing heat treatment after the conductive ink-applying step. Thus, through the through-hole-forming step, a through-hole can be formed in an insulating base. Through the conductive ink-applying step, a conductive ink containing metal particles can be applied onto the insulating base having the through-hole. Furthermore, through the heat-treatment step, unnecessary organic substances and the like in the conductive ink are removed and the metal particles can be reliably fixed to the insulating base, and thus a conductive ink layer can be formed on a surface of the insulating base. Consequently, the thickness of a printed wiring board (mainly, a double-sided printed wiring board) can be reduced, and thus a high-density, high-performance printed wiring board can be provided.

According to the method for producing a printed wiring board according to the twenty-fifth aspect of the present invention, in addition to the operation and effect achieved by the twenty-fourth aspect of the present invention, the method further includes at least an electrolytic plating step of performing electrolytic copper plating after the heat-treatment step; a resist pattern-forming step of forming a resist pattern after the electrolytic plating step; and an etching step of performing etching after the resist pattern-forming step. Thus, through the electrolytic plating step, a plating layer composed of copper can be formed. Through the resist pattern-forming step, a resist pattern can be formed. Through the etching step, an unnecessary conductive layer can be removed. Furthermore, since the printed wiring board is produced by application of a conductive ink, heat treatment, and plating, the printed wiring board can be produced without requiring expensive vacuum equipment and without using an organic adhesive. This method is also advantageous in that various types of bases can be used without limitations in terms of material. By using metal particles on the order of nanometers, a sufficiently dense and uniform conductive ink can be applied, and the plating layer can be formed thereon. Thus, a defect-free, dense, and homogeneous printed wiring board can be produced.

According to the method for producing a printed wiring board according to the twenty-sixth aspect of the present invention, in addition to the operation and effect achieved by the twenty-fifth aspect of the present invention, the method further includes an electroless plating step of performing electroless plating before the electrolytic plating step, and thus the thickness of the conductive ink layer can be made small. Consequently, the amount of ink can be saved, thereby realizing a reduction in cost.

According to the method for producing a printed wiring board according to the twenty-seventh aspect of the present invention, the method includes at least a through-hole-forming step of forming a through-hole in an insulating base; a conductive ink-applying step of applying a conductive ink containing metal particles dispersed in a solvent onto the insulating base having the through-hole, the conductive ink-applying step being performed after the through-hole-forming step; a heat-treatment step of performing heat treatment after the conductive ink-applying step; a resist pattern-forming step of forming a resist pattern after the heat-treatment step; an electrolytic plating step of performing electrolytic copper plating after the resist pattern-forming step; a resist pattern-removing step of removing the resist pattern formed in the resist pattern-forming step, the resist pattern-removing step being performed after the electrolytic plating step; and a conductive ink layer-removing step of removing a conductive ink layer exposed in the resist pattern-removing step, the conductive ink layer-removing step being performed after the resist pattern-removing step. Thus, through the through-hole-forming step, a through-hole can be formed in an insulating base. Through the conductive ink-applying step, a conductive ink containing metal particles can be applied onto the insulating base having the through-hole. Through the heat-treatment step, unnecessary organic substances and the like in the conductive ink are removed and the metal particles can be reliably fixed to the insulating base, and thus a conductive ink layer can be formed on a surface of the insulating base. Through the resist pattern-forming step, a resist pattern can be formed. Through the electrolytic plating step, a plating layer composed of copper can be formed. Through the resist pattern-removing step, the resist pattern can be removed. Through the conductive ink layer-removing step, a conductive ink layer exposed in the resist pattern-removing step can be removed.
That is, the printed wiring board can be produced by a so-called semi-additive process. Thus, a higher-density, higher performance printed wiring board (mainly, a double-sided printed wiring board) can be produced.
Furthermore, since the printed wiring board is produced by application of a conductive ink, heat treatment, and plating, the printed wiring board can be produced without requiring expensive vacuum equipment and without using an organic adhesive. This method is also advantageous in that various types of bases can be used without limitations in terms of material. By using metal particles on the order of nanometers, a sufficiently dense and uniform conductive ink can be applied, and the plating layer can be formed thereon. Thus, a defect-free, dense, and homogeneous printed wiring board can be produced.

According to the method for producing a printed wiring board according to the twenty-eighth aspect of the present invention, in addition to the operation and effect achieved by the twenty-seventh aspect of the present invention, the method further includes an electroless plating step of performing electroless plating before the resist pattern-forming step, and thus the thickness of the conductive ink layer can be made small. Consequently, the amount of ink can be saved, thereby realizing a reduction in cost.

According to the substrate for a printed wiring board according to the twenty-ninth aspect of the present invention, the substrate for a printed wiring board includes an insulating base and copper stacked on a surface of the insulating base, wherein metal particles that suppress oxidation of a copper layer are dispersed and made to adhere to an interface between the insulating base and the copper, and thus it is possible to suppress oxidation of a copper layer at the interface between the insulating base and the copper in an oxidizing atmosphere (in particular, an oxidizing atmosphere at a high temperature).
Thus, separation of the insulating base and the copper layer caused by oxidation of the copper layer can be prevented. Accordingly, a highly reliable substrate for a printed wiring board can be provided.

According to the substrate for a printed wiring board according to the thirtieth aspect of the present invention, in addition to the operation and effect achieved by the twenty-ninth aspect of the present invention, the metal particles include at least Ni particles. Thus, by using Ni particles that do not form a passivation film, a substrate for a printed wiring board having a good etching property can be provided.

According to the substrate for a printed wiring board according to the thirty-first aspect of the present invention, in addition to the operation and effect achieved by the twenty-ninth aspect of the present invention, the metal particles include Ni particles and Cu particles. By incorporating the Cu particles, the Ni particles can be evenly dispersed and made to adhere to the interface between the insulating base and the copper.

According to the method for producing a substrate for a printed wiring board according to the thirty-second aspect of the present invention, the method includes at least a conductive ink-applying step of applying a conductive ink containing metal particles onto a surface of an insulating base; a heat-treatment step of performing heat treatment after the conductive ink-applying step; and an electrolytic plating step of performing electrolytic copper plating after the heat-treatment step. Thus, through the conductive ink-applying step, a conductive ink containing metal particles can be applied onto a surface of an insulating base. Through the heat-treatment step, unnecessary organic substances and the like in the conductive ink are removed, and thus the metal particles can be reliably fixed to the insulating base. Through the electrolytic plating step, a thickness adjustment can be accurately performed, and a plating layer having a predetermined thickness can be formed within a relatively short time. Furthermore, since the substrate for a printed wiring board is produced by application of a conductive ink, heat treatment, and plating, and thus the substrate for a printed wiring board can be produced without requiring expensive vacuum equipment and without using an organic adhesive. This method is also advantageous in that various types of bases can be used without limitations in terms of material. By using metal particles on the order of nanometers, a sufficiently dense and uniform conductive ink can be applied, and the plating layer can be formed thereon. Thus, a defect-free, dense, and homogeneous substrate for a printed wiring board can be produced.
In addition, the application of a conductive ink containing metal particles between the insulating base and the plating layer can suppress oxidation of the plating layer in an oxidizing atmosphere (in particular, an oxidizing atmosphere at a high temperature). Thus, separation of the insulating base and the plating layer caused by oxidation of the plating layer can be prevented. Accordingly, a highly reliable substrate for a printed wiring board can be provided.
As described above, it is possible to produce a substrate for a printed wiring board, the substrate suitable for forming high-density, high-performance, and highly reliable printed wiring including a sufficiently thin conductive layer.

### Advantageous Effects of Invention

According to the substrate for a printed wiring board of the present invention, it is possible to realize high-density, high-performance printed wiring having a sufficiently small thickness using various types of bases that have no limitations in terms of material, without using an organic adhesive, and without limitation in size because expensive vacuum equipment is not necessary for the production.
According to the printed wiring board of the present invention, as in the case of the above substrate for a printed wiring board, it is possible to actually realize high-density, high-performance printed wiring without using an organic adhesive, without limitations in the materials of the base and an underlayer, and without limitations in size because expensive vacuum equipment is not necessary for the production.
Furthermore, according to the method for producing a substrate for a printed wiring board, and the method for producing a printed wiring board using the substrate of the present invention, it is possible to produce a substrate for a printed wiring board and a printed wiring board using the substrate, both of which include a thin, dense, and homogeneous conductive layer suitable for forming high-density, high-performance printed wiring, without using an organic adhesive, without limitations in the material of the base, and without limitation in size because expensive vacuum equipment is not necessary.
Furthermore, it is possible to produce a substrate for a printed wiring board and a printed wiring board using the substrate, in which the growth of an oxide at the interface between an insulating base and a conductive layer can be suppressed in an oxidizing atmosphere (in particular, an oxidizing atmosphere at a high temperature), thereby preventing separation of the insulating base and a plating layer, and which have good etching properties.

### Brief Description of Drawings

[Fig. 1] Figure 1 is a view illustrating a substrate for a printed wiring board according to a first embodiment of the present invention and a method for producing the substrate.
[Fig. 2] Figure 2 includes views illustrating a method for producing a printed wiring board according to the first embodiment of the present invention.
[Fig. 3] Figure 3 includes views illustrating a first example of another method for producing a printed wiring board according to the first embodiment of the present invention.
[Fig. 4] Figure 4 includes views illustrating a second example of another method for producing a printed wiring board according to the first embodiment of the present invention.
[Fig. 5] Figure 5 includes views illustrating an example in which an electroless metal plating portion is formed or an electroless metal plating step is performed on a first conductive layer in a substrate for a printed wiring board, a printed wiring board, and a method for producing the substrate for a printed wiring board according to the first embodiment of the present invention.
[Fig. 6] Figure 6 includes views illustrating a comparison of the operation and effect between the case where an electroless metal plating portion is formed or an electroless metal plating step is performed on a first conductive layer and the case where the electroless metal plating portion is not formed or the electroless metal plating step is not performed on the first conductive layer.
[Fig. 7] Figure 7 includes perspective views each illustrating a substrate for a printed wiring board according to a second embodiment of the present invention, (a) is a view showing a substrate for a printed wiring board, the substrate including one conductive layer on each of an upper surface and a lower surface thereof, and (b) is a view showing a substrate for a printed wiring board, the substrate including two conductive layers on each of an upper surface and a lower surface thereof.
[Fig. 8] Figure 8 includes cross-sectional views illustrating a method for producing a substrate for a printed wiring board and a printed wiring board according to the second embodiment of the present invention.
[Fig. 9] Figure 9 includes cross-sectional views illustrating the method for producing the printed wiring board according to the second embodiment of the present invention.
[Fig. 10] Figure 10 includes cross-sectional views illustrating a modification of the method for producing a printed wiring board according to the second embodiment of the present invention.
[Fig. 11] Figure 11 includes cross-sectional views illustrating a modification of the method for producing the printed wiring board according to the second embodiment of the present invention.
[Fig. 12] Figure 12 includes cross-sectional views illustrating a method for producing an existing printed wiring board.
[Fig. 13] Figure 13 includes cross-sectional views illustrating the method for producing an existing printed wiring board.
[Fig. 14] Figure 14 is a perspective view illustrating a substrate for a printed wiring board according to a third embodiment of the present invention.
[Fig. 15] Figure 15 includes cross-sectional views that schematically illustrate a structure of the substrate for a printed wiring board according to the third embodiment of the present invention.
[Fig. 16] Figure 16 includes cross-sectional views that schematically illustrate structures of existing substrates for a printed wiring board, (a) includes views showing a substrate for a printed wiring board, the substrate including no seed layer, and (b) includes views showing a substrate for a printed wiring board, the substrate including a seed layer.
[Fig. 17] Figure 17 includes cross-sectional views illustrating a method for producing a substrate for a printed wiring board and a printed wiring board using the substrate for a printed wiring board according to the third embodiment of the present invention.
[Fig. 18] Figure 18 includes cross-sectional views illustrating the method for producing the substrate for a printed wiring board and the printed wiring board using the substrate for a printed wiring board according to the third embodiment of the present invention.
[Fig. 19] Figure 19 includes cross-sectional views that schematically illustrate a structure of a modification of the substrate for a printed wiring board according to the third embodiment of the present invention.

### Description of Embodiments

Embodiments of a substrate for a printed wiring board, a printed wiring board, and methods for producing the substrate and the printed wiring board according to the present invention will now be described with reference to the drawings below to understand the present invention. However, the description below relates to embodiments of the present invention and does not limit the scope of Claims.

### [First embodiment]

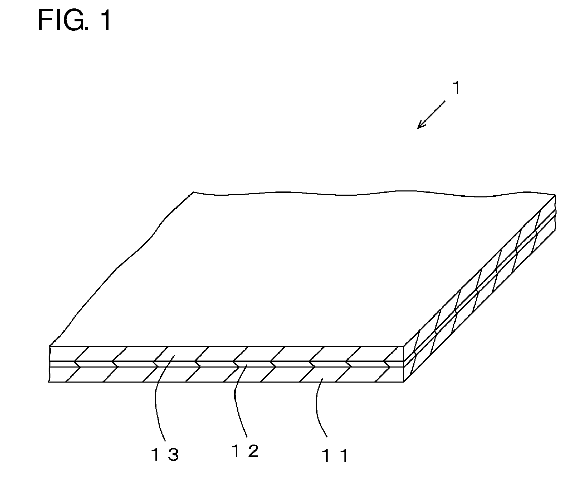

First, a substrate for a printed wiring board according to a first embodiment of the present invention and a method for producing the substrate will now be described with reference to Fig. 1.
A substrate 1 for a printed wiring board according to the first embodiment includes an insulating base 11 formed of a film or a sheet, a first conductive layer 12 stacked on the insulating base 11, and a second conductive layer 13 stacked on the first conductive layer 12, in which the first conductive layer 12 is a coating layer composed of a conductive ink, and the second conductive layer 13 is a plating layer.

The insulating base 11 is a base component for stacking the first conductive layer 12 and the second conductive layer 13 thereon. A thin insulating base 11 is used as a film, and a thick insulating base 11 is used as a sheet.
Examples of the materials of the insulating base 11 that can be used include flexible materials such as polyimides and polyesters; rigid materials such as paper phenol, paper epoxy, glass composites, glass epoxy, Teflon (registered trademark), and glass bases; and rigid-flexible materials which are composites of a hard material and a soft material.
In this embodiment, a polyimide film is used as the insulating base 11.

The first conductive layer 12 has a function of acting as a preliminary treatment for forming a conductive layer on a surface of the insulating base 11, and is a coating layer composed of a conductive ink. By forming the coating layer composed of the conductive ink, the surface of the insulating base 11 can be easily coated with a conductive film without requiring vacuum equipment. Furthermore, the thickness of the second conductive layer 13 can be easily adjusted to a desired value by forming the second conductive layer 13 as a plating layer using the resulting conductive coating layer as a base layer.
Herein, the coating layer composed of the conductive ink constituting the first conductive layer 12 encompasses a layer obtained by applying a conductive ink, and then performing heat treatment such as drying or baking.
In short, any conductive ink may be used as long as a conductive substance can be stacked on the insulating base 11 by applying the conductive ink onto the surface of the insulating base 11.
In this embodiment, a conductive ink containing metal particles functioning as a conductive substance that provides conductivity, a dispersant that disperses the metal particles, and a dispersion medium is used as the conductive ink. By applying such a conductive ink, a coating layer containing fine metal particles is stacked on the insulating base 11.

As the metal particles contained in the conductive ink, at least one element selected from Cu, Ag, Au, Pt, Pd, Ru, Sn, Ni, Fe, Co, Ti, and In can be used. However, from the standpoint of good conductivity, the ease of processing of printed wiring, and an economical cost, Cu is preferably used.
In this embodiment, Cu is used as the coating layer composed of the first conductive layer 12.

Metal particles having a particle diameter of 1 to 500 nm are used as the metal particles contained in the conductive ink. This particle diameter is significantly smaller than that of particles that are usually used for coating, and is believed to be suitable for obtaining a dense conductive thin film. If the particle diameter is less than 1 nm, the dispersibility and stability of the particles in the ink are not necessarily good. In addition, since the particle diameter is excessively small, the coating process for forming a layer is troublesome. If the particle diameter exceeds 500 nm, the particles tend to precipitate, and the resulting coating layer tends to be uneven. In view of, for example, the dispersibility, stability, and prevention of uneven coating, the particle diameter is preferably 30 to 100 nm.

The metal particles contained in the conductive ink can be obtained by a titanium redox method. Herein, the term "titanium redox method" is defined as a method in which ions of a metal element are reduced by an oxidation-reduction action when a trivalent Ti ion is oxidized to a tetravalent ion, thus depositing metal particles. Metal particles obtained by the titanium redox method can have a small and uniform particle diameter, and a spherical or granular shape. Accordingly, the first conductive layer 12 functioning as an underlayer of the second conductive layer 13 can be formed as a thin and dense layer.

The second conductive layer 13 functions as a substantial stacked layer of the conductive layer and is a plating layer formed by electroplating. Alternatively, the plating layer may be formed by a plating method other than electroplating, for example, by an electroless plating method. However, when the second conductive layer 13 is formed by the electroless plating method over the entire thickness of the stacked layer, the process takes a long time, and thus this method is not very practical.
A plating layer formed by the electroplating method is advantageous in that the thickness of the layer can be easily and accurately controlled, and that a desired thickness can be obtained within a relatively short time. Furthermore, by forming the second conductive layer 13 as a plating layer, a dense layer having few defects can be easily obtained.
In the present invention, since a conductive layer serving as an underlayer is formed as the first conductive layer 12 in advance, the second layer can be easily formed by the electroplating method.
The plating layer formed as the second conductive layer 13 is composed of a metal having a good conductivity, such as Cu, Ag, or Au.
The thickness of the second conductive layer 13 is sufficiently larger than the thickness of the first conductive layer 12. The first conductive layer 12 has a function of forming an underlayer necessary for forming the second conductive layer 13 by providing conductivity to the surface of the insulating base 11. Therefore, even a small thickness of the first conductive layer 12 is enough as long as the first conductive layer 12 reliably covers the surface of the insulating base 11. In contrast, the second conductive layer 13 should have a thickness necessary for forming printed wiring.
In this embodiment, as a conductive layer of the substrate for a printed wiring board, the second layer is formed of Cu. In the case where the second conductive layer 13 is formed of Cu, the first conductive layer 12 is preferably formed of Cu. However, other metals having good adhesiveness with Cu can also be used. When, for example, the cost is not considered, the first conductive layer 12 and the second conductive layer 13 are not necessarily formed of Cu. The first conductive layer 12 may be formed of a metal having good adhesiveness to the insulating base 11 and the second conductive layer 13, and the second conductive layer 13 may be formed of a metal having good conductivity.

In order to improve the adhesiveness between the insulating base 11 and the first conductive layer 12, an interlayer composed of at least one element selected from Ni, Cr, Ti, and Si may be made present between the insulating base 11 and the first conductive layer 12. The interlayer can be obtained by treating the resinous insulating base 11 composed of, for example, polyimide with an alkali to expose a functional group on a surface of the resin, and allowing a metal acid to act on the functional group. As for Si, the interlayer can be obtained by performing a silane coupling treatment on the resinous insulating base 11.

Next, a method for producing a substrate for a printed wiring board according to the first embodiment of the present invention will be described.
The method for producing the substrate 1 for a printed wiring board according to the first embodiment includes a step of forming a first conductive layer 12 by applying, onto an insulating base 11, a conductive ink containing metal particles dispersed therein, the metal particles having a particle diameter of 1 to 500 nm, and performing heat treatment, whereby the metal particles in the applied conductive ink are fixed as a metal layer onto the insulating base 11; and a step of forming a second conductive layer 13 by stacking a metal layer on the first conductive layer 12 by plating.

As the insulating base 11, a continuous material that continues in one direction can be used. The substrate for a printed wiring board can be produced by a continuous process using such a continuous material. An independent piece having predetermined dimensions can also be used as the insulating base 11.
Examples of the material used as the insulating base 11 include insulating rigid materials and flexible materials, in addition to polyimide, as described above.
As the conductive ink, an ink containing fine metal particles as a conductive substance, a dispersant for dispersing the metal particles, and a dispersion medium is used.

As for the type and the size of the metal particles that are dispersed in the conductive ink, besides Cu particles having a particle diameter of 1 to 500 nm, other particles described above may also be used.
The metal particles can be produced by any of the following methods besides the titanium redox method described above.

### (Method for producing metal particles)

The metal particles can be produced by a known method such as a high-temperature treatment method called an impregnation method, a liquid-phase reduction method, or a gas-phase method.
In order to produce the metal particles by the liquid-phase reduction method, for example, a water-soluble metal compound used as a source of ions of a metal forming the metal particles, and a dispersant are dissolved in water, a reducing agent is added thereto, and the metal ions are preferably subjected to a reductive reaction under stirring for a certain period of time. In the case where metal particles composed of an alloy are produced by the liquid-phase reduction method, two or more water-soluble metal compounds are used.
In the liquid-phase reduction method, it is possible to produce metal particles having a uniform, spherical or granular shape, a sharp particle size distribution, and a fine particle diameter.
For example, in the case of Cu, examples of the water-soluble metal compound used as a source of metal ions include copper (II) nitrate [Cu(NO₃)₂] and copper (II) sulfate pentahydrate [CuSO₄·5H₂O]. In the case of Ag, examples thereof include silver (I) nitrate [AgNO₃] and silver methanesulfonate [CH₃SO₃Ag]. In the case of Au, an example thereof is a hydrogen tetrachloroaurate (III) tetrahydrate [HAuCl₄·4H₂O]. In the case of Ni, examples thereof include nickel (II) chloride hexahydrate [NiCl₂·6H₂O] and nickel (II) nitrate hexahydrate [Ni(NO₃)₂·6H₂O]. Regarding other metal particles, water-soluble compounds such as chlorides, nitric acid compounds, and sulfuric acid compounds can be used.

### (Reducing agent)

As the reducing agent used in the case where the metal particles are produced by an oxidation-reduction method, various reducing agents that can reduce a metal ion and deposit a metal in the reaction system of a liquid phase (aqueous solution) can be used. Examples thereof include sodium borohydride; sodium hypophosphite; hydrazine; transition metal ions such as a trivalent titanium ion and a divalent cobalt ion; ascorbic acid; reducing sugars such as glucose and fructose; and polyhydric alcohols such as ethylene glycol and glycerin. The titanium redox method described above is a method in which ions of a metal are reduced by an oxidation-reduction action when, among the above reducing agents, a trivalent titanium ion is oxidized to a tetravalent ion, and the metal is deposited.

### (Dispersant of conductive ink)

As the dispersant contained in the conductive ink, it is possible to use various dispersants that have a molecular weight of 2,000 to 30,000 and that can satisfactorily disperse metal particles deposited in a dispersion medium. By using a dispersant having a molecular weight of 2,000 to 30,000, the metal particles can be satisfactorily dispersed in the dispersion medium, and thus the quality of the resulting first conductive layer 12 can be dense and free of defects. If the molecular weight of the dispersant is less than 2,000, the effect of preventing aggregation of metal particles and maintaining dispersion may not be satisfactorily achieved. As a result, the conductive layer stacked on the insulating base 11 may not be formed as a dense layer having few defects. If the molecular weight exceeds 30,000, the volume of the dispersant is excessively large, and thus, during the heat treatment performed after the application of the conductive ink, the dispersant may inhibit sintering of the metal particles, thereby forming voids and decreasing the density of the first conductive layer 11, and decomposed residues of the dispersant may decrease the conductivity.
Note that dispersants that do not contain sulfur, phosphorus, boron, halogen, or alkali are preferable from the standpoint of preventing the degradation of components.
Preferable examples of the dispersant include amine polymer dispersants such as polyethyleneimine and polyvinylpyrrolidone; hydrocarbon polymer dispersants having a carboxylic acid group in its molecule, such as polyacrylic acid and carboxymethyl cellulose; and polymer dispersants having a polar group, such as poval (polyvinyl alcohol), styrene-maleic acid copolymers, olefin-maleic acid copolymers, and copolymers having a polyethyleneimine moiety and a polyethylene oxide moiety in one molecule thereof; all of which have a molecular weight in the range of 2,000 to 30,000.
The dispersant may be added to the reaction system in the form of a solution in which the dispersant is dissolved in water or a water-soluble organic solvent.
The content ratio of the dispersant is preferably 1 to 60 parts by weight based on 100 parts by weight of the metal particles. If the content ratio of the dispersant is less than the above range, in the conductive ink containing water, the effect of surrounding metal particles with the dispersant to prevent the metal particles from being aggregated and to satisfactorily disperse the metal particles may become insufficient. If the content ratio of the dispersant exceeds the above range, during the heat treatment for baking after the application of the conductive ink, the excessive dispersant may inhibit the baking including sintering of the metal particles, thereby forming voids and decreasing the density of the resulting film, and decomposed residues of the polymer dispersant may remain as impurities in the conductive layer, thereby decreasing the conductivity of the printed wiring.

### (Adjustment of particle diameter of metal particles)

In order to adjust the particle diameter of the metal particles, the types and the mixing ratio of the metal compound, the dispersant, and the reducing agent are adjusted, and the stirring speed, the temperature, the time, the pH etc. are adjusted when a reductive reaction of the metal compound is performed.
For example, the pH of the reaction system is preferably 7 to 13 in order to obtain particles having a fine particle diameter as in the present invention.
In order to adjust the pH of the reaction system to be in the range of 7 to 13, a pH adjuster can be used. General acids and alkalis, such as hydrochloric acid, sulfuric acid, sodium hydroxide, and sodium carbonate are used as the pH adjuster. In particular, in order to prevent peripheral components from degrading, nitric acid and ammonia, which do not contain impurity elements such as an alkali metal, an alkaline earth metal, a halogen element such as chlorine, sulfur, phosphorus, or boron are preferable.
In embodiments of the present invention, metal particles having a particle diameter in the range of 30 to 100 nm are used. However, metal particles having a particle diameter in the range of 1 to 500 nm as an allowable range can be used.
Herein, the particle diameter is given as a median diameter D50 of a particle size distribution in a dispersion liquid. The particle diameter was measured using a Microtrac particle size distribution analyzer (UPA-150EX) manufactured by Nikkiso Co., Ltd.

### (Preparation of conductive ink)

Metal particles deposited in a liquid-phase reaction system are subjected to steps of filtration, washing, drying, disintegration, and the like to form a powder. A conductive ink can be prepared using such a powder. In this case, powdered metal particles, water functioning as a dispersion medium, a dispersant, and as required, a water-soluble organic solvent are mixed in a predetermined ratio to prepare a conductive ink containing the metal particles.
Preferably, the conductive ink is prepared using, as a starting material, the reaction system of the liquid phase (aqueous solution) in which the metal particles have been deposited.
Specifically, the liquid phase (aqueous solution) of the reaction system containing the deposited metal particles is subjected to treatments such as ultrafiltration, centrifugal separation, water washing, and electrodialysis to remove impurities, and if necessary, the liquid phase (aqueous solution) is then concentrated to remove water, or, on the contrary, water is then added to the liquid phase (aqueous solution) to adjust the concentration of the metal particles and, if necessary, a water-soluble organic solvent is then further mixed in a certain ratio. Thus, a conductive ink containing the metal particles is prepared. In this method, it is possible to prevent the generation of coarse, irregular particles due to aggregation of the metal particles during drying, and to obtain a dense and uniform first conductive layer 12.

### (Dispersion medium)

The ratio of water used as the dispersion medium in the conductive ink is preferably 20 to 1,900 parts by weight based on 100 parts by weight of the metal particles. If the content ratio of water is less then the above range, the effect of sufficiently swelling the dispersant with water and satisfactorily dispersing the metal particles surrounded by the dispersant may be insufficient. If the content ratio of water exceeds the above range, the proportion of the metal particles in the conductive ink is small, and thus a satisfactory coating layer having a necessary thickness and density may not be formed on the surface of the insulating base 11.

Examples of the organic solvent that is optionally mixed with the conductive ink include various water-soluble organic solvents. Specific examples thereof include alcohols such as methyl alcohol, ethyl alcohol, n-propyl alcohol, isopropyl alcohol, n-butyl alcohol, isobutyl alcohol, sec-butyl alcohol, and tert-butyl alcohol; ketones such as acetone and methyl ethyl ketone; esters of a polyhydric alcohol such as ethylene glycol or glycerin or another compound; and glycol ethers such as ethylene glycol monoethyl ether and diethylene glycol monobuthyl ether.
The content ratio of the water-soluble organic solvent is preferably 30 to 900 parts by weight based on 100 parts by weight of the metal particles. If the content ratio of the water-soluble organic solvent is less than the above range, the effect of adjusting the viscosity and the vapor pressure of a dispersion liquid, the effect being achieved by incorporating the organic solvent, may not be sufficiently obtained. If the content ratio of the water-soluble organic solvent exceeds the above range, the effect of sufficiently swelling the dispersant with water and satisfactorily dispersing the metal particles in the conductive ink using the dispersant without causing aggregation may be insufficient.

### (Application of conductive ink onto insulating base 11)

As a method for applying the conductive ink containing the metal particles dispersed therein onto the insulating base 11, a known coating method such as a spin coating method, a spray coating method, a bar coating method, a die coating method, a slit coating method, a roll coating method, or a dip coating method can be employed. Alternatively, the conductive ink may be applied onto only part of the insulating base 11 by screen printing or using a dispenser or the like.
After the application, drying is performed. The heat treatment described below is then performed.

### (Heat treatment of coating layer)

The conductive ink applied onto the insulating base 11 is heat-treated to obtain the first conductive layer 12 that is fixed to the base as a baked coating layer. The thickness of the conductive layer is preferably 0.05 to 2 μm.
By performing the heat treatment, the dispersant and other organic substances contained in the applied conductive ink are volatilized and decomposed by heat and removed from the coating layer. In addition, by performing the heat treatment, the remaining metal particles are strongly fixed to the insulating base 11 in a sintered state or in a state in which the metal particles are in a stage before sintering and closely contact each other to form a solid bond.
The heat treatment may be performed in air. In order to prevent oxidation of the metal particles, after the baking is performed in air, baking may be further performed in a reducing atmosphere. The temperature of the baking can be 700°C or lower from the standpoint of suppressing an excessive increase in the size of crystal grains of the metal of the first conductive layer 12 formed by the baking, and suppressing the generation of voids.
In the case where the insulating base 11 is composed of an organic resin such as polyimide, the heat treatment is performed at a temperature of 500°C or lower in consideration of heat resistance of the insulating base 11. The lower limit of the heat treatment temperature is preferably 150°C or higher in consideration of a purpose of removing, from the coating layer, organic substances derived from components other than the metal particles contained in the conductive ink.
The atmosphere of the heat treatment may be a non-oxidizing atmosphere in which the O₂ concentration is low, for example, the O₂ concentration is 1,000 ppm or less in order to satisfactorily prevent oxidation of the metal particles particularly in consideration that the metal particles to be stacked are ultrafine particles. Furthermore, the atmosphere of the heat treatment may be a reducing atmosphere obtained by, for example, incorporating hydrogen in a concentration less than the lower explosive limit (3%).
Thus, the steps of applying the conductive ink onto the insulating base 11 and forming the first conductive layer 12 by heat-treating the resulting coating layer are completed.

### (Stacking of second conductive layer 13 by electroplating method)

A metal layer of the second conductive layer 13 to be stacked on the first conductive layer 12 is formed by a plating method. An electroplating method is practically employed. In the present invention, the first conductive layer 12 is formed in advance on the insulating base 11 in order to stack the second conductive layer 13 by electroplating.
By employing the electroplating method, the second conductive layer 13 can be rapidly stacked up to a predetermined stack thickness. The use of the electroplating method is also advantageous in that the second conductive layer 13 can be stacked while accurately controlling the thickness. Furthermore, the resulting second conductive layer 13 can be formed as a homogeneous, defect-free layer.
The thickness of the second conductive layer 13 is determined in accordance with the type of printed circuit to be formed, and is not particularly limited. However, for the purpose of forming high-density, high-performance printed wiring, as a thickness capable of providing such high-density wiring, for example, the thickness of the conductive layer can be 1 μm to several tens of micrometers.
Regarding the relationship between the thickness of the first conductive layer 12 and the thickness of the second conductive layer 13, usually, the thickness of the first conductive layer 12 is small, and the thickness of the second conductive layer 13 is sufficiently larger than that of the first conductive layer 12. Accordingly, the thickness of the second conductive layer 13 can be substantially considered as the thickness of the entire conductive layer.
The electroplating method can be performed so that an electroplating layer having a certain thickness is rapidly formed without defects by using a known electroplating bath suitable for a metal to be plated, such as Cu, Ag, or Au, and selecting appropriate conditions.
Note that the second conductive layer 13 can be stacked by an electroless plating method.

As described above, in order to improve the adhesiveness between the insulating base 11 and the first conductive layer 12, an interlayer composed of at least one element selected from Ni, Cr, Ti, and Si may be made present in advance. In this case, a step of forming the interlayer is performed as a preliminary treatment. In this preliminary treatment, for example, the interlayer is obtained by treating the resinous insulating base 11 composed of, for example, polyimide with an alkali to expose a functional group on a surface of the resin, and allowing a metal acid of the above metal element to act on the functional group. As for the interlayer composed of Si, the interlayer is obtained by performing a silane coupling treatment on the resinous insulating base 11.

### (Printed wiring board produced by using substrate for printed wiring board according to first embodiment)

Next, a description will be made of a printed wiring board produced by using the substrate for a printed wiring board according to the first embodiment of the present invention. The printed wiring board will be described together with a description of a method for producing the printed wiring board.

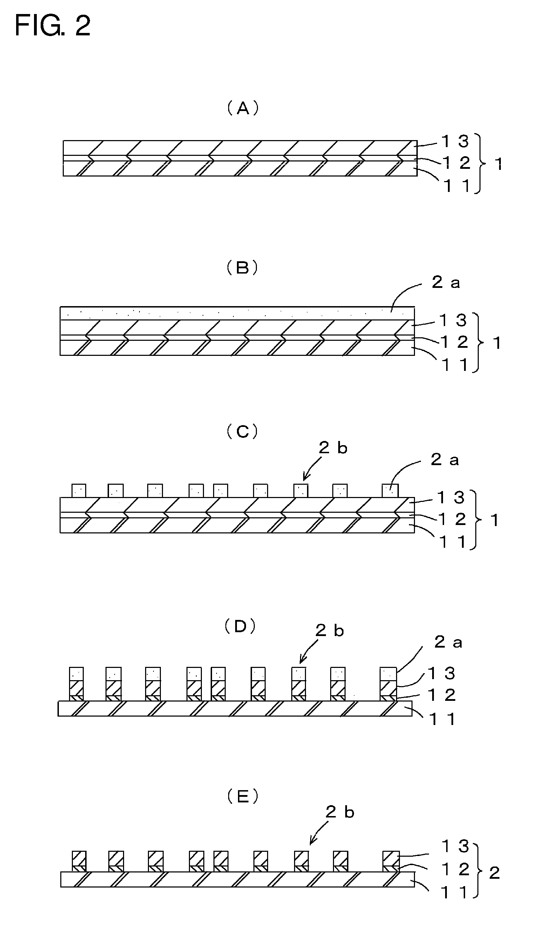

Figure 2 includes views illustrating the method for producing the printed wiring board according to the first embodiment. A printed wiring board 2 according to the first embodiment described here is formed by a subtractive process using the substrate 1 for a printed wiring board of this embodiment.
Specifically, in Fig. 2, first, the substrate 1 for a printed wiring board, the substrate 1 having a certain size, is prepared (A). Next, a photosensitive resist 2a is formed by coating on the substrate 1 for a printed wiring board (B). Subsequently, a wiring pattern 2b is patterned by exposure, development etc. (C). Next, the second conductive layer 13 and first conductive layer 12 located at positions other than the wiring pattern 2b are removed by etching (D). The remaining resist 2a is removed (E).
Thus, the printed wiring board 2 using the substrate 1 for a printed wiring board of the present invention can be obtained.
The printed wiring board 2 using the substrate 1 for a printed wiring board of the first embodiment is not limited to the printed wiring board produced by the subtractive process described above. The printed wiring board 2 also encompasses printed wiring boards produced by any other subtractive processes or any other production processes. In short, printed wiring boards produced by using the substrate 1 for a printed wiring board of the present invention belong to the printed wiring board 2 of the present invention.

### (Another printed wiring board according to first embodiment)

Here, a description will be made of a printed wiring board different from the above-described printed wiring board 2 formed by using the substrate 1 for a printed wiring board of the first embodiment. More specifically, a description will be made of a printed wiring board that does not necessarily require the substrate for a printed wiring board of the present invention, and that includes a pair of a first conductive layer formed of a coating layer composed of a conductive ink and a second conductive layer formed of a plating layer.
Specifically, in the other printed wiring board according to this embodiment, part of a plurality of layers constituting a printed wiring layer includes a pair of a first conductive layer which is a coating layer composed of a conductive ink and a second conductive layer which is a plating layer provided on the first conductive layer. In other words, the printed wiring board is a multilayer board including an insulating base and conductive layers facing each other with the insulating base therebetween, in which at least one of the conductive layers includes a first conductive layer and a second conductive layer, and the first conductive layer is a coating layer composed of a conductive ink and the second conductive layer is a plating layer provided on the first conductive layer.

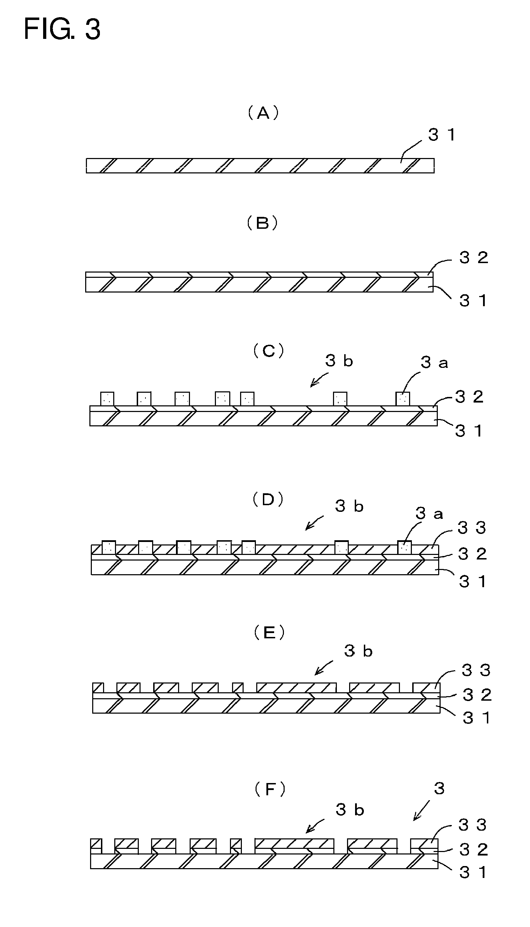

A first example of another printed wiring board according to the first embodiment will now be described with reference to Fig. 3.
In this first example, a printed wiring board 3 is produced by a semi-additive process in the order of (A) to (F) of Fig. 3 using an insulating base 31 as an underlayer.
Specifically, first, the insulating base 31 is prepared (A). The insulating base 31 may be composed of the same material as the above-described insulating base 11, such as polyimide.
Next, a conductive ink in which metal particles having a particle diameter of 1 to 500 nm are dispersed is applied onto the insulating base 31, which serves as the underlayer, and heat treatment is performed, thus stacking a first conductive layer 32 as a coating layer (B). Copper particles obtained by the titanium redox method are typically used as the metal particles. Alternatively, other various metal particles described above can also be used. In addition, the above-described conductive ink can also be used as the conductive ink. Furthermore, the above-described heat treatment conditions can also be used in the heat treatment.
Next, a resist 3a is formed on the first conductive layer 32 so that areas where a wiring pattern 3b is not to be formed are covered with the resist 3a (C).
Next, a second conductive layer 33 is stacked by an electroplating method on areas to be formed into the wiring pattern 3b, the areas being located at positions other than the resist 3a (D).
Next, the resist 3a is removed (E).
Next, etching is performed so as to remove the first conductive layer 32 located at positions from which the resist 3a has been removed (F).
Thus, the printed wiring board 3 is obtained.
The printed wiring board 3 includes a plurality of layers, and some of the layers constitute a printed wiring layer. In addition, part of the plurality of layers includes a pair of the first conductive layer 32 and the second conductive layer 33.

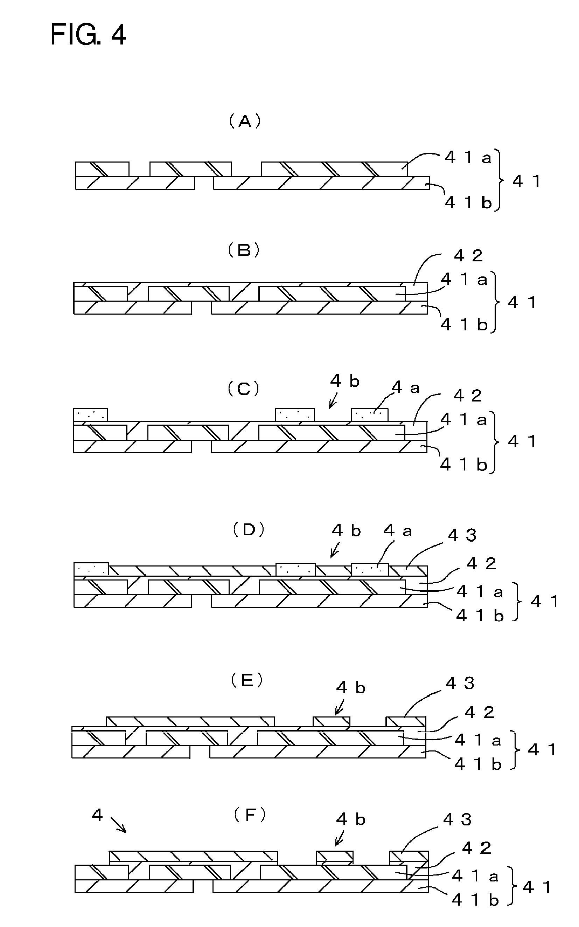

A second example of another printed wiring board according to the first embodiment will now be described with reference to Fig. 4.
In this second example, a printed wiring board 4 is produced by a semi-additive process in the order of (A) to (F) of Fig. 4 using, as an underlayer, a printed wiring layer 41 that has already been formed.
Specifically, first, a product formed of the printed wiring layer 41 is prepared (A). Specifically, this printed wiring layer 41 is a printed wiring board including an insulating base 41a and a conductive layer 41b. A product prepared before circuits are formed can also be used as the underlayer. The configuration and the production method of this printed wiring layer 41 are not particularly limited, and any known configuration and production method can be used.
Next, a conductive ink in which metal particles having a particle diameter of 1 to 500 nm are dispersed is applied onto the insulating base 41a side of the printed wiring layer 41, which serves as the underlayer, and heat treatment is performed, thus stacking a first conductive layer 42 as a coating layer (B). Copper particles obtained by the titanium redox method described above or other metal particles can be used as the metal particles. In addition, the above-described conductive ink and heat treatment conditions can also be used as the conductive ink and the heat treatment conditions.
Next, a resist 4a is formed on the first conductive layer 42 so that areas where a wiring pattern 4b is not to be formed are covered with the resist 4a (C).
Next, a second conductive layer 43 is stacked by an electroplating method on areas to be formed into the wiring pattern 4b, the areas being located at positions other than the resist 4a (D).
Next, the resist 4a is removed (E).
Next, etching is performed so as to remove the first conductive layer 42 located at positions from which the resist 4a has been removed (F).
Thus, the printed wiring board 4 is obtained.
The printed wiring board 4 includes a plurality of layers, and some of the layers constitute the printed wiring layer 41. In addition, part of the plurality of layers includes a pair of the first conductive layer 42 and the second conductive layer 43. Furthermore, as is apparent from Fig. 4, at least part of the second conductive layer 43 can be configured to be electrically connected to the conductive layer 41b of the printed wiring layer 41, which serves as the underlayer. By using the first conductive layer 42 composed of a coating layer and the second conductive layer 43 in this manner, it is possible to easily provide a multilayered high-density printed wiring board 4 in which an upper printed wiring layer and a lower printed wiring layer are electrically connected to each other.

The substrate for a printed wiring board, the printed wiring boards, and the methods for producing the substrate for a printed wiring board include, as a main configuration and a main production method, applying and stacking the first conductive layer 12 (32, 42) onto the base 11 (31, 41) using a conductive ink, and then stacking the second conductive layer 13 (33, 43) by electroplating. However, it is effective to perform an electroless metal plating step on the first conductive layer 12 (32, 42) after the step of forming the first conductive layer 12 (32, 42) using the conductive ink and before the step of stacking the second conductive layer 13 (33, 43).
It is conceivable that a layer of Cu, Ag, Ni, or the like is formed by electroless metal plating. However, in the case where the first conductive layer 12 (32, 42) and the second conductive layer 13 (33, 43) are each composed of Cu, Cu or Ni is preferable in view of the adhesiveness and the cost.

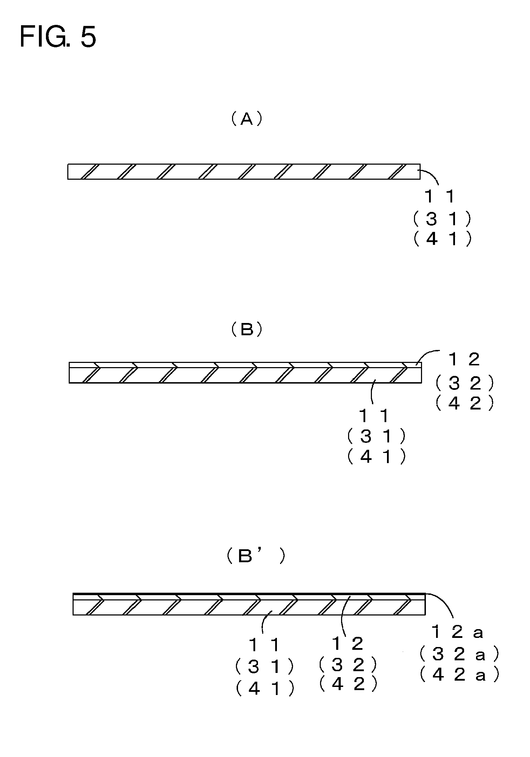

Specifically, on the base 11 (31, 41) shown in Fig. 5(A), the first conductive layer 12 (32, 42) shown is Fig. 5(B) is formed, and electroless metal plating is then performed on the first conductive layer 12 (32, 42) to form an electroless metal plating portion 12a (32a, 42a) shown in Fig. 5(B'). Thus, void portions present in the first conductive layer 12 (32, 42) are filled with the electroless metal plating portion 12a (32a, 42a).
The electroless metal plating portion 12a (32a, 42a) fills void portions V described below of the first conductive layer 12 (32, 42), more specifically, void portions V communicating with the surface of the first conductive layer 12 (32, 42). Herein, the term "fill" means that the base 11 (31, 41) is covered with the electroless metal plating portion 12a (32a, 42a) so that the base 11 (31, 41) is not exposed to at least the bottom of the void portions V communicating with the surface. Accordingly, the formation of the electroless metal plating portion 12a (32a, 42a) includes a case where the electroless metal plating portion 12a (32a, 42a) fills the void portions V of the first conductive layer 12 (32, 42) up to the surface level of the first conductive layer 12 (32, 42) so as to be aligned with the surface, a case where the electroless metal plating portion 12a (32a, 42a) fills the void portions V up to a level below the surface of the first conductive layer 12 (32, 42), and a case where the electroless metal plating portion 12a (32a, 42a) fills the void portions V up to a level exceeding the surface of the first conductive layer 12 (32, 42). In the case where the void portions V are filled with the electroless metal plating portion 12a (32a, 42a) up to a level exceeding the surface of the first conductive layer 12 (32, 42), an electroless metal plating layer is stacked on the surface of the first conductive layer 12 (32, 42) to a certain degree. Such a case is also included in above-described "fill".
By forming the electroless metal plating portion 12a (32a, 42a), the entire surface of the first conductive layer 12 becomes a surface composed of a metal, i.e., a conductive substance. Consequently, when the second conductive layer 13 (33, 43) is subsequently stacked by an electroplating method, a dense layer can be obtained.

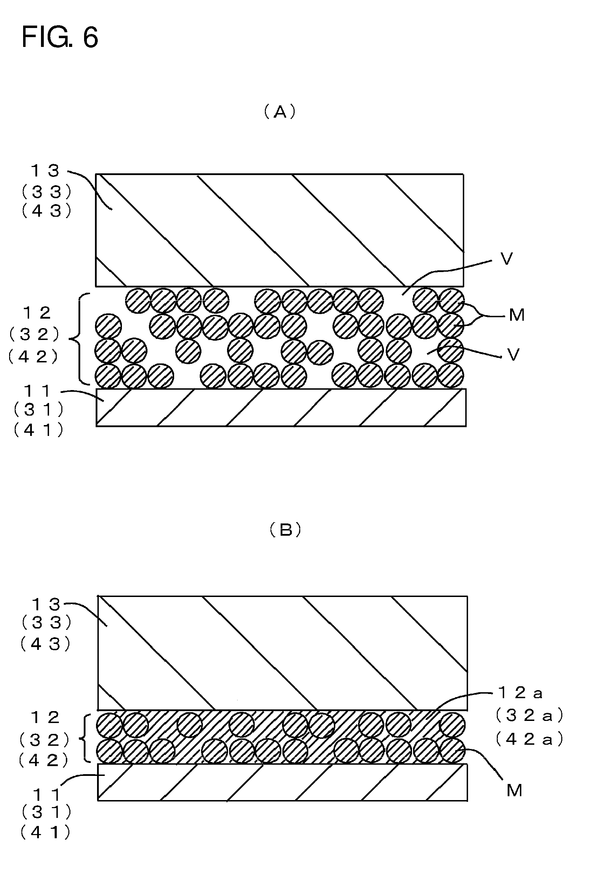

A description will be made of the operations and effects in the case where the electroless metal plating portion 12a (32a, 42a) is formed on the first conductive layer 12 (32, 42) by an electroless metal plating method, and the case where the electroless metal plating portion 12a (32a, 42a) is not formed with reference to Figs. 6(A) and 6(B).
Figure 6(A) is a schematic view illustrating a state where the electroless metal plating is not performed. In this case, voids V remain as they are in the first conductive layer 12 (32, 42), which is a coating layer composed of a conductive ink. Therefore, the voids V may become break starting points, which tends to cause separation of the first conductive layer 12 (32, 42).
Furthermore, when the electroless metal plating is not performed, it is necessary to increase the coating thickness of the first conductive layer 12 (32, 42) in order to decrease non-conductive portions formed of the voids V, resulting in an increase in the cost.
In Figs. 6(A) and 6(B), M indicates a metal particle of the first conductive layer 12 (32, 42) formed by coating.

Figure 6(B) is a schematic view illustrating a state where the electroless metal plating is performed. In this case, voids V communicating with the surface of the first conductive layer 12 (32, 42), which is a coating layer composed of a conductive ink, are filled with the electroless metal plating portion 12a (32a, 42a). As a result, the first conductive layer 12 (32, 42) becomes dense. When the first conductive layer 12 (32, 42) becomes dense, the number of break starting points (separation starting points) inside the first conductive layer 12 (32, 42) decreases, and thus separation of the first conductive layer 12 (32, 42) can be suppressed during the subsequent production steps etc.
Factors of the separation of the first conductive layer 12 (32, 42) include, for example, in the production method of the embodiment shown in Fig. 3, permeation of a resist solvent in the step shown in Fig. 3(C), separation due to a plating stress in the step shown in Fig. 3(D), permeation of a resist-removing solvent in the step shown in Fig. 3(E), and permeation of a first conductive layer-removing liquid shown in Fig. 3(F).
In addition, since the voids V are filled with the electroless metal plating portion 12a (32a, 42a) to eliminate non-conductive portions, a small thickness can be realized without increasing the thickness of the first conductive layer 12 (32, 42) itself. In order to form the second conductive layer 13 (33, 43) by an electroplating method, it is necessary that any two points in the first conductive layer 12 (32, 42) be electrically connected to each other. If a non-conductive portion is formed in the first conductive layer 12 (32, 42), a plating layer cannot be formed on the non-conductive portion during the electroplating, resulting in a circuit failure. If the first conductive layer 12 (32, 42) having a large thickness is formed by coating so as to obtain a reliably conductive first conductive layer 12 (32, 42), the cost is increased, and the number of voids V increases, resulting in an increase in break starting points. It is also conceivable to form the second conductive layer 13 (33, 43) by electroless plating. However, when a layer having a thickness of 1 μm to several tens of micrometers is formed by electroless plating, the cost is higher than that in the case of electroplating.

In the electroless metal plating, for example, electroless Cu plating is performed with treatments such as a cleaner step, a water washing step, an acid treatment step, a water washing step, a pre-dip step, an activator step, a water washing step, a reducing step, and a water washing step. As a specific example of this electroless Cu plating, the plating is performed using, as reagents, for example, Basic Printgant M1 (85 mL/L), Copper Printgant MSK (45 mL/L), Stabilizer Printgant M1 (1.5 mL/L), Starter Printgant M1 (8 mL/L), and Reducer Cu (16 mL/L), all of which are trade names and manufactured by Atotech Japan Co., Ltd., at 35°C for 10 minutes.

### EXAMPLE 1

A conductive ink in which copper particles having a particle diameter of 40 nm were dispersed in water as a solvent and which had a copper concentration of 8% by weight was prepared. This conductive ink was applied onto a polyimide film (Kapton EN), which is an insulating base, and dried at 60°C for 10 minutes in air. Heat treatment was further performed at 250°C for 30 minutes in a nitrogen atmosphere (oxygen concentration: 100 ppm). The resistance of a first conductive layer thus obtained was 40 μΩcm. Furthermore, copper electroplating was performed on the first conductive layer. Thus, a substrate for a printed wiring board, the substrate having a thickness of 12 μm, was obtained.

### EXAMPLE 2

The experiment was performed as in Example 1 except that the atmosphere of the heat treatment was changed to an atmosphere containing 3% of hydrogen and 97% of nitrogen. The resistance of a first conductive layer thus obtained was 10 μΩcm. Furthermore, copper electroplating was performed on the first conductive layer. Thus, a substrate for a printed wiring board, the substrate having a copper thickness of 12 μm, was obtained.

### [Second embodiment]

A substrate for a printed wiring board, a method for producing the substrate, a printed wiring board, and a method for producing the printed wiring board according to a second embodiment of the present invention will now be described with reference the drawings below to understand the present invention. However, the description below relates to an embodiment of the present invention and does not limit the scope of Claims.

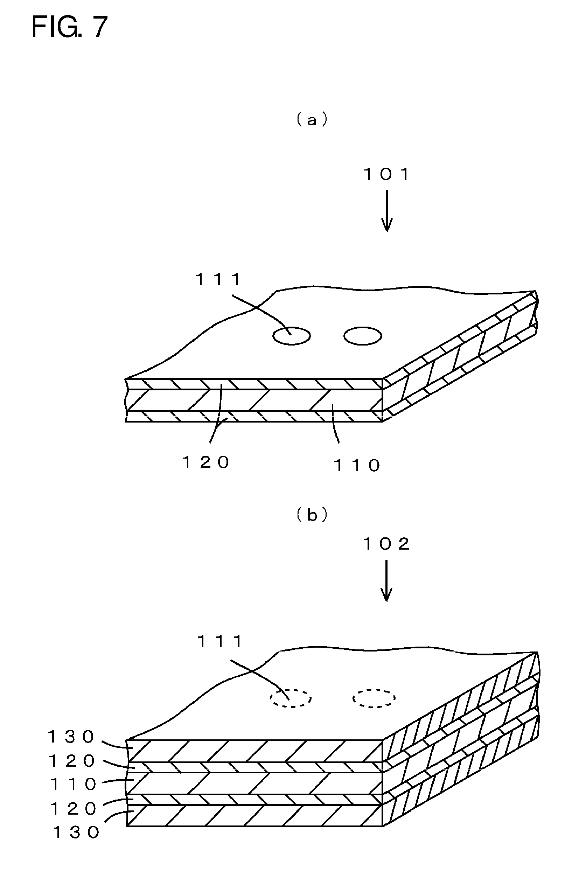

First, the substrate for a printed wiring board, the method for producing the substrate, the printed wiring board, and the method for producing the printed wiring board according to the second embodiment of the present invention will now be described with reference to Figs. 7 to 9.
First, a substrate 1 for a printed wiring board according to the second embodiment will be described with reference to Fig. 7(a).
A substrate 101 for a printed wiring board is a substrate for a printed wiring board, the substrate having a single conductive layer on each of the upper surface and the lower surface thereof. The substrate 101 includes an insulating base 110 formed of a film or a sheet and a conductive ink layer 120 coating the upper surface and the lower surface of the insulating base 110.
As shown in Fig. 7(a), the substrate 101 for a printed wiring board has through-holes 111 penetrating the insulating base 110.
The number and the formation position etc. of the through-holes 111 are not limited to those of this embodiment, and can be appropriately changed.

The insulating base 110 is a base component for stacking the conductive ink layer 120 thereon. The insulating base 110 having a small thickness is used as a film, and the insulating base 110 having a large thickness is used as a sheet.
As for the material of the insulating base 110, the same materials as those described in the first embodiment can be used.
A polyimide film is used as the insulating base 110 also in this second embodiment.

The conductive ink layer 120 functions as a conductive layer coating the entire inner surfaces of the through-holes 111 formed in the insulating base 110 and both surfaces of the insulating base 110, and are formed by applying a conductive ink containing metal particles onto the surfaces of the insulating base 110. By forming the coating layers of the conductive ink, both surfaces of the insulating base 110 can be easily covered with a conductive coating film without requiring vacuum equipment.
Herein, the conductive ink layer 120 encompasses a layer obtained by applying a conductive ink, and then performing heat treatment such as drying or baking.
In short, any conductive ink may be used as long as a conductive substance can be stacked by applying the conductive ink onto the entire inner surfaces of the through-holes 111 formed in the insulating base 110 and both surfaces of the insulating base 110.
In the second embodiment, a conductive ink containing metal particles functioning as a conductive substance that provides conductivity, a dispersant that disperses the metal particles, and a dispersion medium is used as the conductive ink. By applying such a conductive ink, a coating layer containing fine metal particles is stacked on both surfaces of the insulating base 110.

As the metal particles contained in the conductive ink, at least one element selected from Cu, Ag, Au, Pt, Pd, Ru, Sn, Ni, Fe, Co, Ti, and In can be used as in the first embodiment. However, from the standpoint of good conductivity, the ease of processing of printed wiring, and an economical cost, Cu is preferably used.
Copper is used also in the second embodiment.

Metal particles having a particle diameter of 1 to 500 nm are used as the metal particles contained in the conductive ink. This particle diameter is significantly smaller than that of particles that are usually used for coating, and is believed to be suitable for obtaining a dense conductive thin film. If the particle diameter is less than 1 nm, the dispersibility and stability of the particles in the ink are not necessarily good. In addition, since the particle diameter is excessively small, the coating process for forming a layer is troublesome. If the particle diameter exceeds 500 nm, the particles tend to precipitate, and the resulting coating layer tends to be uneven. In view of, for example, the dispersibility, stability, and prevention of uneven coating, the particle diameter is preferably 30 to 100 nm.

As described above, the metal particles contained in the conductive ink can be prepared by the titanium redox method, which can provide particles having a small and uniform particle diameter, and a spherical or granular shape. Accordingly, the conductive ink layer 120 can be formed as a thin and dense layer.

In the second embodiment, the substrate 101 for a printed wiring board is a substrate for a printed wiring board, the substrate having a single conductive layer on each of the upper surface and the lower surface thereof. However, the configuration is not necessarily limited thereto. For example, as shown in Fig. 7(b), a conductive ink layer 120 may be formed as first conductive layer, and a plating layer 130 which is a second conductive layer may be stacked on the first conductive layer by an electrolytic plating process (so-called electroplating method). Thus, the substrate may be a substrate 102 for a printed wiring board, the substrate 102 having two conductive layers on each of the upper surface and the lower surface thereof.

In order to improve the adhesiveness between the insulating base 110 and the conductive ink layer 120, an interlayer composed of at least one element selected from Ni, Cr, Ti, and Si may be made present between the insulating base 110 and the conductive ink layer 120. The interlayer can be obtained by treating the resinous insulating base 110 composed of, for example, polyimide with an alkali to expose a functional group on a surface of the resin, and allowing a metal acid to act on the functional group. As for Si, the interlayer can be obtained by performing a silane coupling treatment on the resinous insulating base 110.

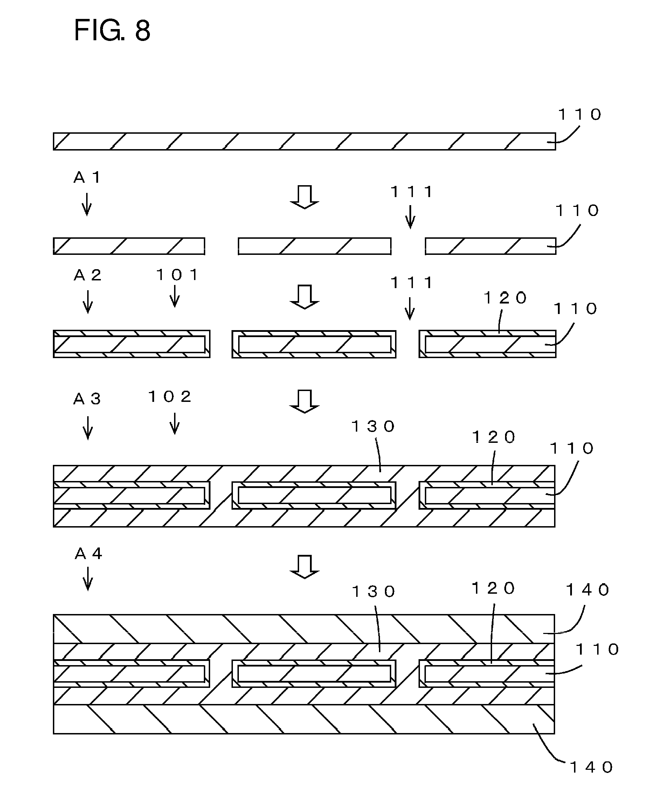

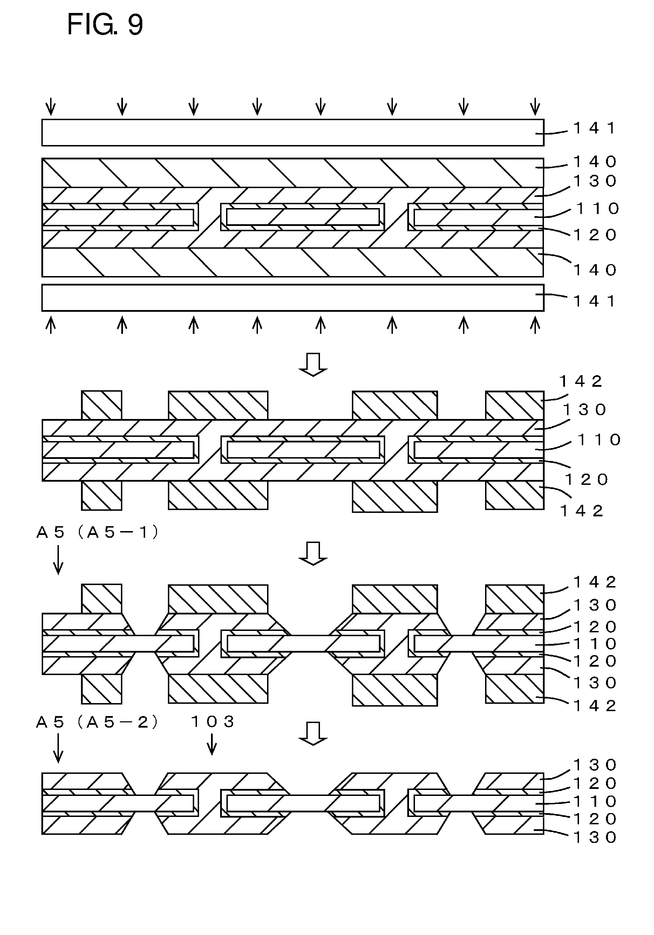

A substrate for a printed wiring board, a method for producing the substrate, a printed wiring board, and a method for producing the printed wiring board according to the second embodiment of the present invention will now be described further with reference to Figs. 8 and 9.
A printed wiring board 103 according to the second embodiment is a double-sided printed wiring board including a conductive ink layer 120 which is a first conductive layer and a plating layer 130 which is a second conductive layer, the plating layer 130 being formed by forming a plating layer on the entire inner surfaces of through-holes 111 formed in a substrate 101 for a printed wiring board and on both surfaces of the substrate 101 for a printed wiring board.
This printed wiring board 103 is produced by a so-called subtractive process using the substrate 101 for a printed wiring board of the second embodiment.

More specifically, referring to Figs. 8 and 9, the printed wiring board 103 is produced through a through-hole-forming step A1 of forming a through-hole 111 in an insulating base 110; a conductive ink-applying step A2 of applying a conductive ink containing metal particles dispersed in a solvent onto the insulating base 110 having the through-hole 111, the conductive ink-applying step A2 being performed after the through-hole-forming step A1; a heat-treatment step (not shown in the figures) of performing heat treatment after the conductive ink-applying step A2; a plating step A3 of performing electrolytic copper plating after the heat-treatment step, a resist pattern-forming step A4 of forming a resist pattern after the plating step A3; and a wiring circuit-forming step A5 of forming a wiring circuit after the resist pattern-forming step A4.

First, referring to Fig. 8, in the through-hole-forming step A1, through-holes 111 are formed in an insulating base 110 by drilling, laser machining, or the like.
Subsequently, in the conductive ink-applying step A2, a conductive ink containing metal particles are applied onto the entire inner surfaces of the through-holes 111 and an upper surface and a lower surface of the insulating base 110.
Next, in the heat-treatment step (not shown), the metal particles in the applied conductive ink are fixed as a metal layer to the insulating base 110. As a result, a conductive ink layer 120 containing the metal particles and serving as a conductive layer is formed on the entire inner surfaces of the through-holes 111 formed in the insulating base 110 and both surfaces of the insulating base 110.
Thus, the substrate 101 for a printed wiring board, the substrate 101 being shown in Fig. 7(a) and having a single conductive layer on each of the upper surface and the lower surface thereof, is produced.

Next, as shown in Fig. 8, in the plating step A3, a plating layer 130 is formed on the entire inner surfaces of the through-holes 111 and both surfaces of the insulating base 110 by an electrolytic plating process (so-called electroplating method) using copper.
Thus, a conductive layer including the conductive ink layer 120 serving as a first conductive layer and the plating layer 130 stacked on the first conductive layer and serving as a second conductive layer is formed. That is, the substrate 102 for a printed wiring board, the substrate 102 being shown in Fig. 7(b) and having two conductive layers on each of the upper surface and the lower surface thereof, is produced.

Subsequently, as shown in Figs. 8 and 9, in the resist pattern-forming step A4, a resist 140 is stacked on the plating layer 130, exposure is performed in this state using a pattern mask 141, and development is performed. Thus, a resist pattern 142 is formed so as to cover portions to be formed into a wiring pattern.
Next, as shown in Fig. 9, in an etching step A5-1 of the wiring circuit-forming step A5, unnecessary portions of the conductive layer, which are other than the portions to be formed into the wiring pattern, are removed.
Subsequently, in a resist pattern-removing step A5-2 of the wiring circuit-forming step A5, the resist pattern 142 is removed.
The printed wiring board 103 using the substrate 101 for a printed wiring board according to the second embodiment is produced through the above steps.

In the second embodiment, the plating layer 130 is formed by only the electrolytic plating process (so-called electroplating method), but the method is not necessarily limited thereto.
For example, before the electrolytic plating process, an electroless plating process may be performed.
With this configuration, the thickness of the conductive ink layer 120 which is the first conductive layer can be reduced. Consequently, it is possible to provide a substrate 101 for a printed wiring board and a printed wiring board 103 in which the amount of ink can be saved and thus the cost can be reduced.
The metal used in the electrolytic plating process is also not limited to copper (Cu). Alternatively, a metal having good conductivity, such as silver (Ag) or gold (Au) may be used.
Furthermore, the method for producing the printed wiring board 103 using the substrate 101 for a printed wiring board of the second embodiment is not limited to the subtractive process described above. The printed wiring board 103 also encompasses printed wiring boards produced by any other subtractive processes or any other production processes. In short, printed wiring boards produced by using the substrate 101 for a printed wiring board of the second embodiment belong to the printed wiring board 103 of the present embodiment.

The configurations of the substrate 101 for a printed wiring board and the printed wiring board 103, and methods for producing the substrate 101 and the printed wiring board 103 will now be described in more detail.

### (Configuration of insulating base)

As the insulating base 110, a continuous material that continues in one direction can be used. The substrate 101 for a printed wiring board can be produced by a continuous process using such a continuous material. An independent piece having predetermined dimensions can also be used as the insulating base 110.
Examples of the material used as the insulating base 110 include insulating rigid materials and flexible materials, in addition to polyimide, as described above.
As the conductive ink, an ink containing fine metal particles as a conductive substance, a dispersant for dispersing the metal particles, and a dispersion medium is used.

As for the type and the size of the metal particles that are dispersed in the conductive ink, besides Cu particles having a particle diameter of 1 to 500 nm, other particles described above may also be used.
Examples of the method for producing the metal particles include not only the titanium redox method described above but also the following methods.

The methods for producing the metal particles, the reducing agent used in the case where the metal particles are produced by an oxidation-reduction method, the dispersant and dispersion medium contained in the conductive ink are as described above.
The adjustment of the particle diameter of the metal particles and the preparation of the conductive ink are also as described above.
The methods for applying the conductive ink, in which metal particles are dispersed, onto the insulating base 10 are also as described above.

### (Heat treatment of coating layer)

The conductive ink applied onto the insulating base 110 is heat-treated to obtain a conductive ink layer 120 that is fixed to the base as a baked coating layer. The thickness of the conductive ink layer 120 is preferably 0.05 to 2 μm.
The heat treatment of the coating layer has been described above.

### (Stacking of plating layer in plating step)

The plating layer 130 to be stacked on the conductive ink layer 120 is formed in the plating step A3. The stacking is practically performed by an electrolytic plating process (so-called electroplating method) using copper (Cu). In the second embodiment, since the conductive ink layer 120 which is the first conductive layer is formed as an underlayer in advance, the plating layer 130 which is the second conductive layer can be easily formed by the electroplating method.
By employing the electrolytic plating process, the plating layer 130 can be rapidly stacked up to a predetermined stack thickness. The use of the electrolytic plating process is also advantageous in that the plating layer 130 can be stacked while accurately controlling the thickness. Furthermore, the resulting plating layer 130 can be formed as a homogeneous, defect-free layer.
The thickness of the plating layer 130 is determined in accordance with the type of printed circuit to be formed, and is not particularly limited. However, for the purpose of forming high-density, high-performance printed wiring, as a thickness capable of providing such high-density wiring, for example, the thickness of the conductive layer can be 1 μm to several tens of micrometers.
Regarding the relationship between the thickness of the conductive ink layer 120 which is the first conductive layer and the thickness of the plating layer 130 which is the second conductive layer, the conductive ink layer 120 which is the first conductive layer has a function of forming an underlayer necessary for forming the plating layer 130 which is the second conductive layer by providing conductivity to the surface of the insulating base 110. Therefore, even a small thickness of the conductive ink layer 120 is enough as long as the conductive ink layer 120 reliably covers both surfaces of the insulating base 110. In contrast, the plating layer 130 should have a thickness necessary for forming printed wiring. Accordingly, the thickness of the plating layer 130 can be substantially considered as the thickness of the entire conductive layer.
The electrolytic plating process (so-called electroplating method) can be performed so that an electroplating layer having a certain thickness is rapidly formed without defects by using a known electroplating bath and selecting appropriate conditions.
In the second embodiment, as a conductive layer of the substrate 101 for a printed ring board, the conductive ink layer 120 which is the first conductive layer is formed of Cu. In the case where the plating layer 130 which is the second conductive layer is formed of Cu, the conductive ink layer 120 is preferably formed of Cu. However, other metals having good adhesiveness with Cu can also be used. When, for example, the cost is not considered, the conductive ink layer 120 and the plating layer 130 are not necessarily formed of Cu. The conductive ink layer 120 may be formed of a metal having good adhesiveness to the insulating base 110 and the plating layer 130, and the plating layer 130 may be formed of a metal having good conductivity.

As described above, in order to improve the adhesiveness between the insulating base 110 and the conductive ink layer 120 which is the first conductive layer, an interlayer composed of at least one element selected from Ni, Cr, Ti, and Si may be made present in advance. In this case, a step of forming the interlayer is performed as a preliminary treatment. In this preliminary treatment, for example, the interlayer is obtained by treating the resinous insulating base 110 composed of, for example, polyimide with an alkali to expose a functional group on a surface of the resin, and allowing a metal acid of the above metal element to act on the functional group. As for the interlayer composed of Si, the interlayer is obtained by performing a silane coupling treatment on the resinous insulating base 110.

As described above, according to the printed wiring board 103 obtained by using the substrate 101 for a printed wiring board of the second embodiment, and the method for producing the printed wiring board 103, expensive vacuum equipment is not necessary for the production, thus reducing the equipment-related costs, a high production efficiency can be achieved, and there is no limitation in terms of size, as compared with an existing double-sided printed wiring board and an existing method for producing the double-sided printed wiring board. Furthermore, a high density, a high performance, and a sufficiently small thickness of a conductive layer can be realized by using various types of bases that have no limitations in terms of material, without performing a desmear process, and without using an organic adhesive. Furthermore, etching can be performed with high accuracy in the etching step (a so-called uneven etching can be prevented). It is also possible to realize mass production of a high-density, high-performance double-sided printed wiring board.

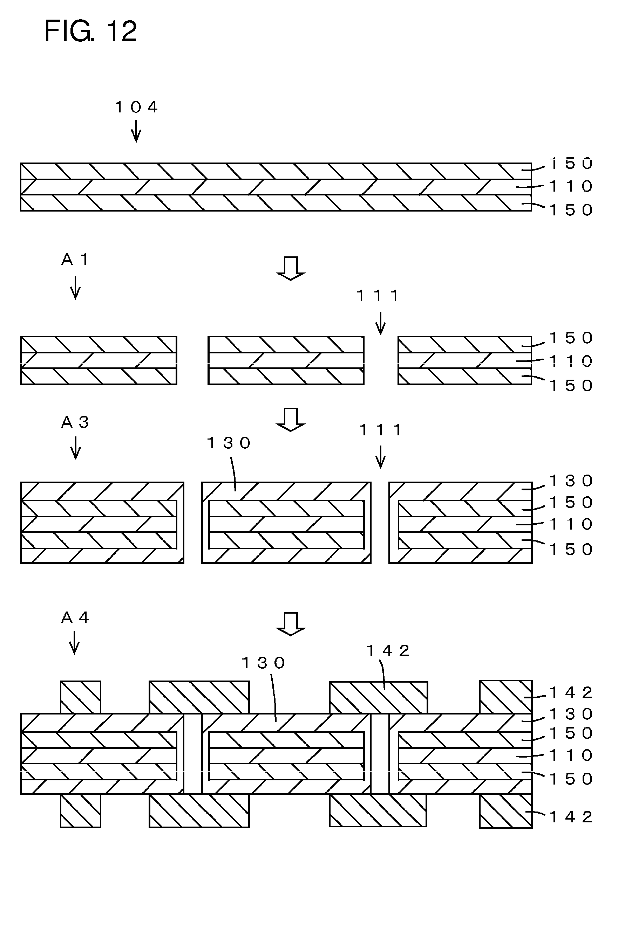

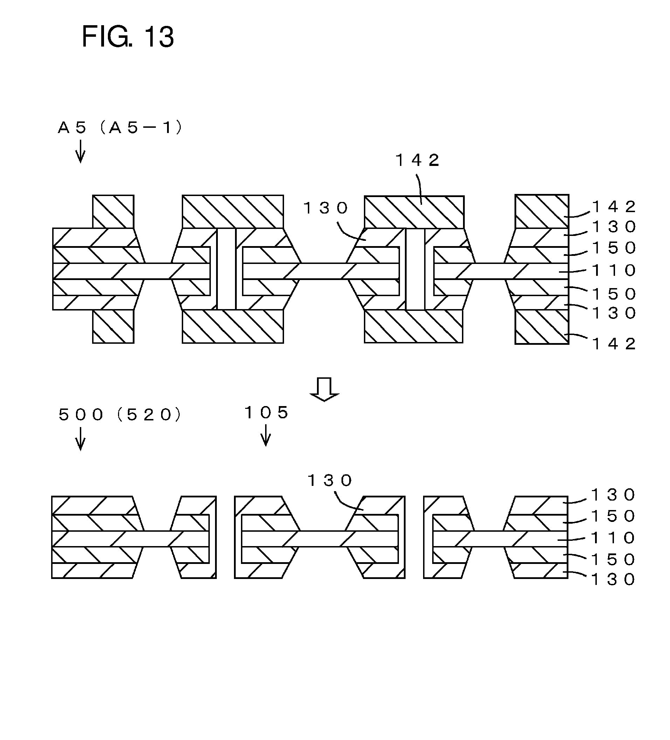

In fact, as shown in Figs. 12 and 13, an existing double-sided printed wiring board 105 is generally produced through the following steps using a copper-clad laminated substrate 104 including an insulating base 110 and conductive layers 150 formed by stacking a copper thin film on each of the upper surface and the lower surface of the insulating base 110 by a sputtering method. Specifically, first, in a through-hole-forming step A1, through-holes 111 are formed, and a desmear process is then performed. In a plating step A3, a plating layer 130 is formed by performing an electroless plating process and an electrolytic plating process. Subsequently, a resist pattern-forming step A4 and a wiring circuit-forming step A5 are performed.
Thus, vacuum equipment for performing the sputtering method is necessary, and the equipment-related costs, namely, the costs of installation, maintenance, and operation of the equipment are high. In addition, all operations such as the supply of the insulating base 110 used, the formation of a thin film, and the storage of the insulating base 110 must be performed in a vacuum. In addition, it is necessary to perform the desmear process after the formation of the through-holes 111. Thus, the production efficiency is low, and the degree to which the insulating base 110 can be increased in size is limited.
Furthermore, the thickness of the wiring circuit is the sum of the thickness of the original copper-clad laminated substrate 104 and the thickness of the plating layer 130. Accordingly, the wiring circuit has a large thickness, it is difficult to form a high-density, high-performance wiring circuit, and it is difficult to accurately perform etching in the etching step (a problem of a so-called uneven etching occurs).

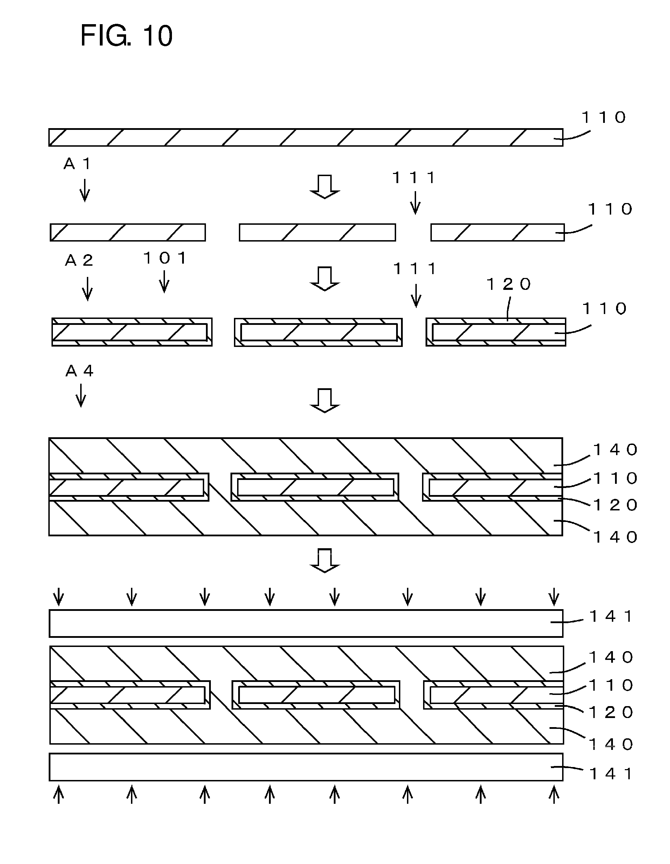

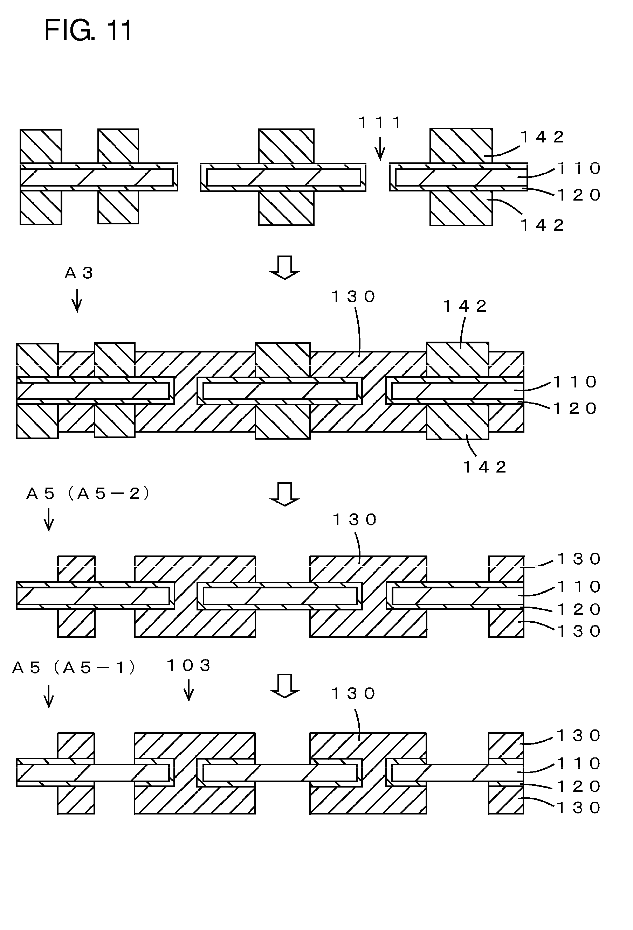

Next, a modification of the method for producing a printed wiring board according to the second embodiment will be described with reference to Figs. 10 and 11.
This modification is a method for producing a printed wiring board 103 using a substrate 101 for a printed wiring board by a semi-additive process. Other configurations are the same as those in the above-described second embodiment of the present invention. The same components as those in the above second embodiment, and components having the same functions as those in the second embodiment are assigned the same reference numerals, and a description of those components is omitted.

First, referring to Fig. 10, in a through-hole-forming step A1, through-holes 111 are formed in an insulating base 110 by drilling, laser machining, or the like.
Next, in a conductive ink-applying step A2, a conductive ink containing metal particles are applied onto the entire inner surfaces of the through-holes 111 and an upper surface and a lower surface of the insulating base 110.
Next, in a heat-treatment step (not shown), the metal particles in the applied conductive ink are fixed as a metal layer to the insulating base 110. As a result, a conductive ink layer 120 containing the metal particles and serving as a conductive layer is formed on the upper surface and the lower surface of the insulating base 110.
Thus, a substrate 101 for a printed wiring board is produced as shown in Fig. 10.

Next, in a resist pattern-forming step A4, a resist 140 is stacked on both surfaces of the substrate 101 for a printed wiring board, exposure is performed in this state using a pattern mask 141, and development is performed. Thus, as shown in Fig. 11, a resist pattern 142 is formed so as to cover portions other than portions to be formed into a wiring pattern.
Next, in a plating step A3, a plating layer 130 is formed on the portions to be formed into the wiring pattern by an electrolytic plating process (so-called electroplating method) using copper (Cu).
Thus, a conductive layer including the conductive ink layer 120 serving as a first conductive layer and the plating layer 130 stacked on the first conductive layer and serving as a second conductive layer is formed. That is, the plating layer 130 which is the second conductive layer is formed as a pattern on the conductive ink layer 120, which is the first conductive layer and which functions as an underlayer, by a semi-additive process using the resist 140.

Subsequently, as shown in Fig. 11, a resist pattern-removing step A5-2 of a wiring circuit-forming step A5, the resist pattern 142 is removed.
Next, in an etching step A5-1 of the wiring circuit-forming step A5, the conductive ink layer 120 which has been exposed in the resist pattern-removing step A5-2 is removed.
The printed wiring board 103 using the substrate 101 for a printed wiring board according to this modification is produced through the above steps.
In this modification, before the resist pattern-forming step A4, an electroless plating process for coating the entire inner surfaces of the through-holes 111 and both surfaces of the insulating base 110 with an electroless plating layer may be performed.
With this configuration, the thickness of the conductive ink layer 120 which is the first conductive layer can be reduced. Consequently, it is possible to provide a substrate 101 for a printed wiring board and a printed wiring board 103 in which the amount of ink can be saved and thus the cost can be reduced.

### EXAMPLE 3

A conductive ink in which copper particles having a particle diameter of 40 nm were dispersed in water as a solvent and which had a copper concentration of 8% by weight was prepared. A polyimide film (Kapton EN) which is an insulating base having through-holes therein was prepared. The conductive ink was applied onto the entire inner surfaces of the through-holes and an upper surface and a lower surface of the polyimide film, and dried at 60°C for 10 minutes in air. Heat treatment was further performed at 250°C for 30 minutes in a nitrogen atmosphere (oxygen concentration: 100 ppm). The resistance of a conductive ink layer thus obtained was 40 μΩcm. Furthermore, copper electroplating was performed on the upper surface and the lower surface of the conductive ink layer. Thus, a substrate for a printed wiring board, the substrate having a thickness of 12 μm, was obtained.

### EXAMPLE 4

The experiment was performed as in Example 3 except that the atmosphere of the heat treatment was changed to an atmosphere containing 3% of hydrogen and 97% of nitrogen. The resistance of a conductive ink layer thus obtained was 10 μΩcm. Furthermore, copper electroplating was performed on the conductive ink layer. Thus, a substrate for a printed wiring board, the substrate having a copper thickness of 12 μm, was obtained.

### [Third embodiment]

A third embodiment of the present invention will now be described with reference the drawings below to understand the present invention. However, the description below relates to an embodiment of the present invention and does not limit the scope of Claims.

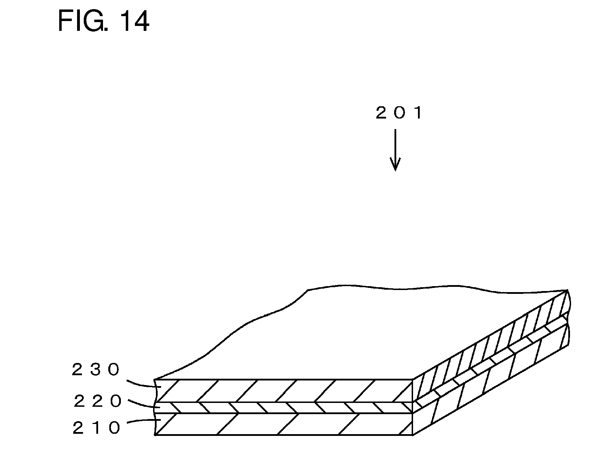

First, a substrate for a printed wiring board, a method for producing the substrate, a printed wiring board using the substrate for a printed wiring board, and a method for producing the printed wiring board according to the third embodiment of the present invention will now be described with reference to Figs. 14 to 18.
First, a substrate 201 for a printed wiring board according to the third embodiment will be described with reference to Fig. 14.
The substrate 201 for a printed wiring board is a substrate for a printed wiring board, in which copper is stacked on a surface of an insulating base. The substrate 201 includes an insulating base 210 formed of a film or a sheet, a conductive ink layer 220 formed of a conductive ink and serving as a first conductive layer, and a plating layer 230 composed of copper and serving as a second conductive layer.

The insulating base 210 is a base component for stacking the conductive ink layer 220 thereon. The insulating base 210 having a small thickness is used as a film, and the insulating base 210 having a large thickness is used as a sheet.
As for the material of the insulating base 210, the same materials as those described in the first embodiment and the second embodiment can be used.
A polyimide film is used as the insulating base 210 also in this third embodiment.

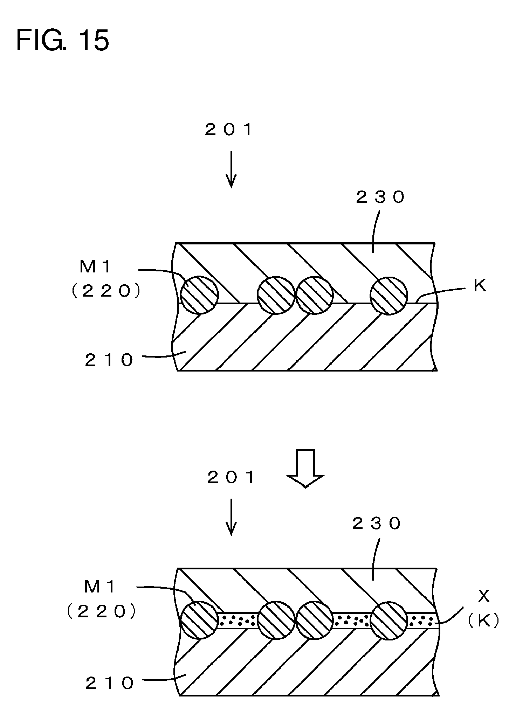

The conductive ink layer 220 is a conductive layer that constitutes an underlayer of the plating layer 230 composed of copper and that has an effect of suppressing the growth of copper oxide. The conductive ink layer 220 is formed by applying a conductive ink containing metal particles onto a surface of the insulating base 210.
In this third embodiment, nickel (Ni) particles are used as the metal particles.
With this configuration in which nickel (Ni) particles are used as the metal particles, as shown in the upper portion of Fig. 15, metal particles M1 (nickel particles) can be dispersed and made to adhere to an interface K between the insulating base 210 and the plating layer 230 formed of copper because nickel (Ni) does not form a passivation film.
Accordingly, it is possible to suppress oxidation of the plating layer 230 at the interface K between the insulating base 210 and the plating layer 230 in an oxidizing atmosphere (in particular, an oxidizing atmosphere at a high temperature).
Herein, the phrase "in an oxidizing atmosphere at a high temperature" refers to various situations in which the substrate 201 for a printed wiring board is placed in an oxidizing atmosphere at a high temperature, namely, a stage of producing the substrate 201 for a printed wiring board, such as a heat-treatment step, e.g., drying or baking, and a stage of using the substrate 201 for a printed wiring board, such as a stage of producing a printed wiring board using the substrate 201 for a printed wiring board.

More specifically, as shown in the upper portion of Fig. 15, in the case where the substrate 201 for a printed wiring board, in which the metal particles M1 (nickel particles) are dispersed and made to adhere to the interface K between the insulating base 210 and the plating layer 230, is placed in an oxidizing atmosphere at a high temperature, as shown in the lower portion of Fig. 15, a copper oxide layer X is grown only on areas of the interface K where the metal particles M1 are not present. In other words, it is possible to prevent the copper oxide layer X from uniformly growing at the interface K. Consequently, this non-uniform copper oxide layer X provides an anchoring effect to prevent a decrease in the adhesive force between the insulating base 210 and the plating layer 230.
Thus, it is possible to effectively prevent separation of the insulating base 210 and the plating layer 230. Accordingly, a highly reliable substrate 201 for a printed wiring board can be provided.
In addition, as shown in Fig. 15, since the nickel (Ni) used as the metal particles are present at the interface K in the form of particles, the surface area per unit volume can be increased. Therefore, for example, when a printed wiring board is formed using the substrate 201 for a printed wiring board, a satisfactory etching property can be realized.

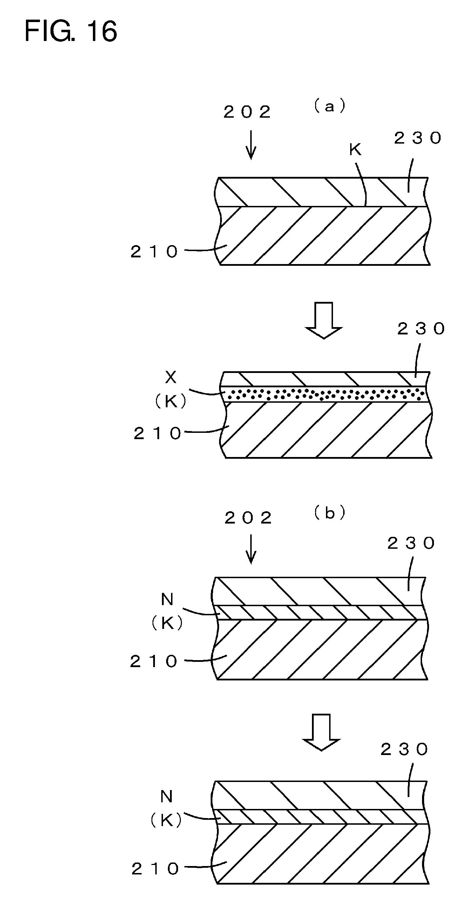

Specifically, as shown in the upper portion of Fig. 16(a), in a substrate 202 for a printed wiring board, the substrate 202 being produced by forming the plating layer 230 formed of copper and serving as a conductive layer on a surface of an insulating base 210 by a sputtering method, as shown in the lower portion of Fig. 16(a), a copper oxide layer X is grown as a uniform layer at an interface K between the insulating base 210 and the plating layer 230 in an oxidizing atmosphere at a high temperature. As a result, a problem of separation of the plating layer 230 tends to occur because the copper oxide layer X becomes a starting point.
To solve this problem, as shown in Fig 16(b), a metallic substance having a high oxidation prevention effect (e.g., chromium (Cr)) is deposited by a sputtering method at the interface K between the insulating base 210 and the plating layer 230 which is a conductive layer, thereby forming a seed layer N (so-called barrier layer).
However, in the case where the seed layer N is formed by such a sputtering method, in order to form a uniform seed layer N on the insulating base 210, it is necessary to uniformly deposit a metallic substance having a high barrier effect on the insulating base 210. As a result, the metallic substance having a high barrier effect forms a layer that is difficult to be etched. Consequently, there have been problems in that, for example, in the case where a printed wiring board is produced using the substrate 202 for a printed wiring board, it takes a long time to remove the seed layer N in an etching step, and that the number of production steps is increased.
In contrast, according to the substrate 201 for a printed wiring board of the third embodiment, it is possible to realize both the prevention of separation of the plating layer 230 caused by the growth of an oxide in an oxidizing atmosphere at a high temperature and a satisfactory etching property in an etching step. Consequently, a substrate 201 for a printed wiring board, the substrate 201 having high reliability and good processability, can be provided.
In addition, by forming a coating layer composed of a conductive ink, the conductive ink layer 220 can be easily formed on the surface of the insulating base 210 without requiring vacuum equipment. Consequently, the conductive ink layer 220 can be used as an underlayer of the plating layer 230, thereby easily forming the plating layer 230.

Herein, the conductive ink layer 220 encompasses a layer obtained by applying a conductive ink, and then performing heat treatment such as drying or baking.
In short, any conductive ink may be used as long as a conductive substance can be stacked on the insulating base 210 by applying the conductive ink onto the surface of the insulating base 210.
In this third embodiment, a conductive ink containing metal particles M1 functioning as a conductive substance that provides conductivity, a dispersant that disperses the metal particles M1, and a dispersion medium is used as the conductive ink. By applying such a conductive ink, a coating layer containing fine metal particles L is formed on the surface of the insulating base 210.

In the third embodiment, nickel (Ni) is used as the metal particles M1 contained in the conductive ink. However, the metal particles are not necessarily limited thereto. Instead of nickel (Ni), at least one element selected from copper (Cu), titanium (Ti), and vanadium (V) and oxides thereof may also be used.

As described above, metal particles having a particle diameter of 1 to 500 nm are used as the metal particles M1 contained in the conductive ink. This particle diameter is significantly smaller than that of particles that are usually used for coating, and is believed to be suitable for obtaining a dense conductive thin film. If the particle diameter is less than 1 nm, the dispersibility and stability of the particles in the ink are not necessarily good. In addition, since the particle diameter is excessively small, the coating process for forming a layer is troublesome. If the particle diameter exceeds 500 nm, the particles tend to precipitate, and the resulting coating layer tends to be uneven. In view of, for example, the dispersibility, stability, and prevention of uneven coating, the particle diameter is preferably 30 to 100 nm.

Regarding the number of metal particles M1 per unit area (per 1 mm²), when the particle diameter of the metal particles M1 is 10 nm, the number of metal particles M1 is preferably 1 × 10⁹ to 1 × 10¹¹. When the particle diameter of the metal particles M1 is 50 nm, the number of metal particles M1 is preferably 5 × 10⁷ to 4.6 × 10⁹. When the particle diameter of the metal particles M1 is 100 nm, the number of metal particles M1 is preferably 1 × 10⁸ to 1 × 10¹⁰.
Specifically, when the metal particles M1 is assumed to be spherical, the coating ratio is preferably 0.1 to 10. More preferably, the coating ratio is 0.2 to 3.

As described above, the metal particles M1 contained in the conductive ink can be prepared by the titanium redox method, which can provide particles having a small and uniform particle diameter, and a spherical or granular shape. Accordingly, the conductive ink layer 220 can be formed as a thin and dense layer.

The plating layer 230 is a conductive layer that is stacked on the surface of the insulating base 210 with the conductive ink layer 220 therebetween, and is formed by an electrolytic plating process (so-called electroplating method) using copper. In this embodiment, since the conductive ink layer 220 which is the first conductive layer is formed in advance as an underlayer, the plating layer 230 which is the second conductive layer can be easily formed by the electroplating method.
By employing the electrolytic plating process, the plating layer 230 can be rapidly stacked up to a predetermined stack thickness. The use of the electrolytic plating process is also advantageous in that the plating layer 230 can be stacked while accurately controlling the thickness. Furthermore, the resulting plating layer 230 can be formed as a homogeneous, defect-free layer.

The thickness of the plating layer 230 is determined in accordance with the type of printed wiring circuit to be formed, and is not particularly limited. However, for the purpose of forming high-density, high-performance printed wiring, as a thickness capable of providing such high-density wiring, for example, the thickness of the conductive layer can be 1 µm to several tens of micrometers.
The electrolytic plating process (so-called electroplating method) can be performed so that an electroplating layer having a certain thickness is rapidly formed without defects by using a known electroplating bath and selecting appropriate conditions.

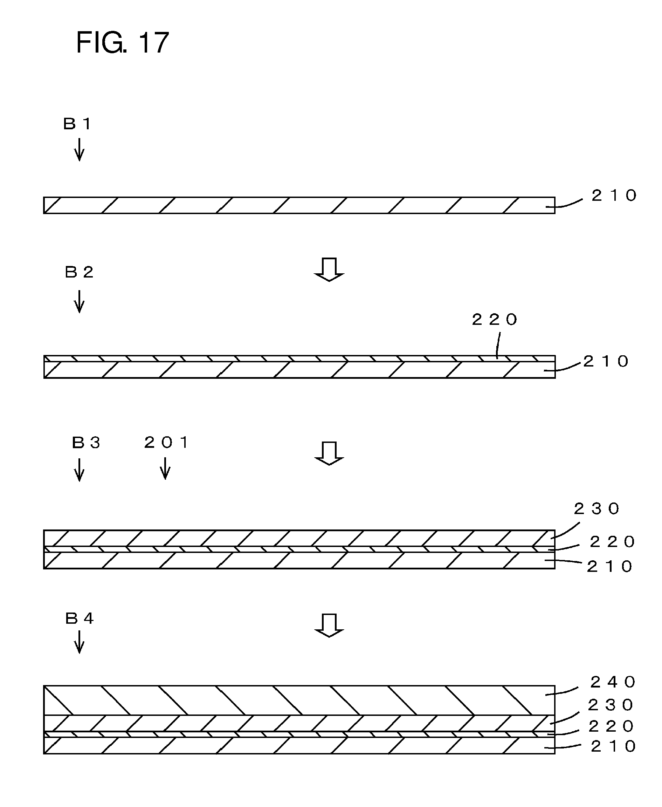

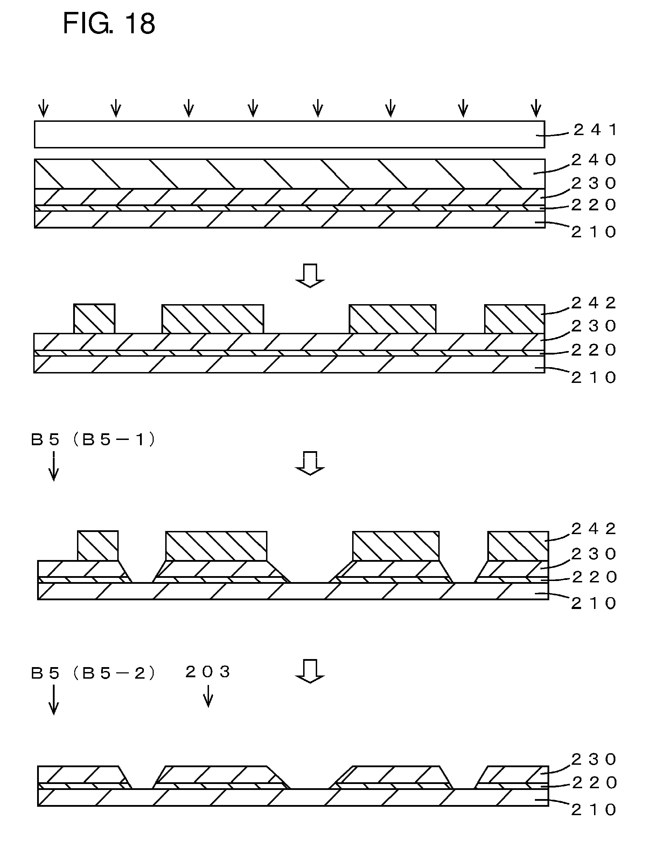

Next, a method for producing a substrate for a printed wiring board according to the third embodiment of the present invention will be described with reference to Figs. 17 and 18 by way of a method for producing a printed wiring board using the substrate for a printed wiring board.
A printed wiring board 203 using a substrate 201 for a printed wiring board according to the third embodiment is a printed wiring board including a conductive ink layer 220 serving as a first conductive layer and a plating layer 230 serving as a second conductive layer.
This printed wiring board 203 is produced by a so-called subtractive process using the substrate 201 for a printed wiring board of this embodiment.

More specifically, the printed wiring board 203 is produced through a pretreatment step B1; a conductive ink-applying step B2 of applying a conductive ink dispersed in a solvent onto an insulating base 210; a heat-treatment step (not shown) of performing heat treatment after the conductive ink-applying step B2; a plating step B3 of performing electrolytic copper plating after the heat-treatment step; a resist pattern-forming step B4 of forming a resist pattern after the plating step B3; and a wiring circuit-forming step B5 of forming a wiring circuit after the resist pattern-forming step B4.

First, referring to Fig. 17, in the pretreatment step B1, an alkali treatment is performed on a surface of an insulating base 210.
More specifically, the insulating base 210 is immersed in an aqueous sodium hydroxide solution, and is then washed with water, washed with an acid, washed with water, and dried. Imide bonds of the insulating base 210 composed of a polyimide film are decomposed in this pretreatment step B 1 to produce a carboxyl group and a carbonyl group.
In this embodiment, an alkali treatment is used in the pretreatment step B1, but the pretreatment step B 1 is not necessarily limited thereto. For example, a plasma treatment may also be used.

Next, in the conductive ink-applying step B2, a conductive ink containing nickel (Ni) particles which are metal particles M1 is applied onto a surface of the insulating base 210.
Next, in the heat-treatment step (not shown), the metal particles M1 in the applied conductive ink are fixed as a metal layer to the insulating base 210. Thus, a conductive ink layer 220 containing the metal particles M1 and functioning as a conductive layer is formed on the surface of the insulating base 210.

Next, in the plating step B3, a plating layer 230 is formed on the surface of the insulating base 210 with the conductive ink layer 220 therebetween.
More specifically, the plating layer 230 is formed by an electrolytic plating process (so-called electroplating method) using copper.
Thus, the conductive layer including the conductive ink layer 220 as a first conductive layer and the plating layer 230 as a second conductive layer is formed. Specifically, the substrate 201 for a printed wiring board shown in Fig. 14 is produced.

Subsequently, as shown in Figs. 17 and 18, in the resist pattern-forming step B4, a resist 240 is stacked on the plating layer 230, exposure is performed in this state using a pattern mask 241, and development is performed. Thus, a resist pattern 242 is formed so as to cover portions to be formed into a wiring pattern.
Next, as shown in Fig. 18, in an etching step B5-1 of the wiring circuit-forming step B5, unnecessary portions of the conductive layer, which are other than the portions to be formed into the wiring pattern, are removed.
Subsequently, in a resist pattern-removing step B5-2 of the wiring circuit-forming step B5, the resist pattern 242 is removed.
The printed wiring board 203 using the substrate 201 for a printed wiring board according to the third embodiment is produced through the above steps.

The method for producing the printed wiring board 203 using the substrate 201 for a printed wiring board of the third embodiment is not limited to the subtractive process described above. The printed wiring board 203 also encompasses printed wiring boards produced by any other subtractive processes, a semi-additive process, or any other production processes.

The configurations of the substrate 201 for a printed wiring board and the printed wiring board 203 using the printed wiring board 201, and methods for producing the substrate 201 and the printed wiring board 203 will now be described in more detail.

### (Configuration of insulating base)

As the insulating base 210, a continuous material that continues in one direction can be used. The substrate 201 for a printed wiring board can be produced by a continuous process using such a continuous material. An independent piece having predetermined dimensions can also be used as the insulating base 210.
Examples of the material used as the insulating base 210 include insulating rigid materials and flexible materials, in addition to polyimide, as described above.
As the conductive ink, an ink containing fine metal particles M1 as a conductive substance, a dispersant for dispersing the metal particles M1, and a dispersion medium is used.

As for the type and the size of the metal particles M1 that are dispersed in the conductive ink, besides nickel (Ni) particles having a particle diameter of 1 to 500 nm, other particles described above may also be used.
Examples of the method for producing the metal particles M1 include not only the titanium redox method described above but also the following methods.

The metal particles M1 can be produced by any of the known methods described above.
As a reducing agent used in the case where the metal particles M1 are produced by an oxidation-reduction method, the above-described reducing agents can be used.
The dispersant and dispersion medium contained in the conductive ink are as described above.
The adjustment of the particle diameter of the metal particles M1 and the preparation of the conductive ink are also as described above.

### (Application of conductive ink onto insulating base)

As a method for applying, onto the insulating base 210, the conductive ink in which the metal particles M1 are dispersed, a known coating method such as a spin coating method, a spray coating method, a bar coating method, a die coating method, a slit coating method, a roll coating method, or a dip coating method can be employed. Alternatively, the conductive ink may be applied onto only part the insulating base 210 by screen printing or using a dispenser or the like.
After the application, drying is performed. The heat treatment described below is then performed.

### (Heat treatment of coating layer)

The conductive ink applied onto the insulating base 210 is heat-treated to obtain a conductive ink layer 220 that is fixed to the base as a baked coating layer. The thickness of the conductive ink layer 220 is preferably 0.05 to 2 µm.
By performing the heat treatment, the dispersant and other organic substances contained in the applied conductive ink are volatilized and decomposed by heat and removed from the coating layer. In addition, by performing the heat treatment, the remaining metal particles M1 are strongly fixed to the insulating base 210 in a sintered state or in a state in which the metal particles M1 are in a stage before sintering and closely contact each other to form a solid bond.
The heat treatment may be performed in air. In order to prevent oxidation of the metal particles M1, after the baking is performed in air, baking may be further performed in a reducing atmosphere. The temperature of the baking can be 700°C or lower from the standpoint of suppressing an excessive increase in the size of crystal grains of the metal of the conductive ink layer 220 formed by the baking, and suppressing the generation of voids.
In the case where the insulating base 210 is composed of an organic resin such as polyimide, the heat treatment is performed at a temperature of 500°C or lower in consideration of heat resistance of the insulating base 210. The lower limit of the heat treatment temperature is preferably 150°C or higher in consideration of a purpose of removing, from the coating layer, organic substances derived from components other than the metal particles M1 contained in the conductive ink.
The atmosphere of the heat treatment may be a non-oxidizing atmosphere in which the O₂ concentration is low, for example, the O₂ concentration is 1,000 ppm or less in order to satisfactorily prevent oxidation of the metal particles M1 particularly in consideration that the metal particles M1 to be stacked are ultrafine particles. Furthermore, the atmosphere of the heat treatment may be a reducing atmosphere obtained by, for example, incorporating hydrogen in a concentration less than the lower explosive limit (3%).
Thus, the steps of applying the conductive ink onto the insulating base 210 and forming the conductive ink layer 220 by heat-treating the resulting coating layer are completed.

### (Stacking of plating layer in plating step)

The plating layer 230 to be stacked on the surface of the insulating base 210 with the conductive ink layer 220 therebetween is formed in the plating step B3. The stacking is practically performed by an electrolytic plating process (so-called electroplating method) using copper (Cu).
Regarding the relationship between the thickness of the conductive ink layer 220 which is the first conductive layer and the thickness of the plating layer 230 which is the second conductive layer, the conductive ink layer 220 which is the first conductive layer has a function of forming an underlayer necessary for forming the plating layer 230 which is the second conductive layer by providing conductivity to the surface of the insulating base 210. Therefore, even a small thickness of the conductive ink layer 220 is enough as long as the conductive ink layer 220 reliably covers both surfaces of the insulating base 210. In contrast, the plating layer 230 should have a thickness necessary for forming printed wiring. Accordingly, the thickness of the plating layer 230 can be substantially considered as the thickness of the entire conductive layer.
In the third embodiment, as a conductive layer of the substrate 201 for a printed wiring board, the conductive ink layer 220 which is the first conductive layer is formed of nickel (Ni). In the case where the plating layer 230 which is the second conductive layer is formed of copper (Cu), the conductive ink layer 220 can be formed of a metal that is other than nickel (Ni) and that has good adhesiveness with copper (Cu). However, nickel (Ni) is preferably used.
In this embodiment, the plating step B3 includes only an electrolytic plating process. Alternatively, the plating step B3 may include an electroless plating process for coating the surface of the insulating base 210 with an electroless plating layer, the electroless plating process being performed before the electrolytic plating process.
With this configuration, the thickness of the conductive ink layer 220 which is the first conductive layer can be reduced. Consequently, it is possible to provide a substrate 201 for a printed wiring board and a printed wiring board 203 in which the amount of ink can be saved and thus the cost can be reduced.

As described above, according to the substrate 201 for a printed wiring board, the method for producing the substrate 201, the printed wiring board 203 using the substrate 201 for a printed wiring board, and the method for producing the printed wiring board 203 of the third embodiment, expensive vacuum equipment is not necessary for the production, thus reducing the equipment-related costs, a high production efficiency can be achieved, and there is no limitation in terms of size, as compared with existing substrates for printed wiring boards, the substrates each including a conductive layer formed by a sputtering method, and existing printed wiring boards using such substrates for printed wiring boards. Furthermore, a high density, a high performance, and a sufficiently small thickness of a conductive layer can be realized by using various types of bases that have no limitations in terms of material and without using an organic adhesive. Furthermore, it is possible to prevent the growth of an oxide at the interface K between the insulating base 210 and the plating layer 230 in an oxidizing atmosphere (in particular, an oxidizing atmosphere at a high temperature), and thus separation of the insulating base 210 and the plating layer 230 can be prevented. In addition, a substrate 201 for a printed wiring board and a printed wiring board 203 which have a good etching property can be provided. It is also possible to realize mass production of a high-density, high-performance printed wiring board 203.

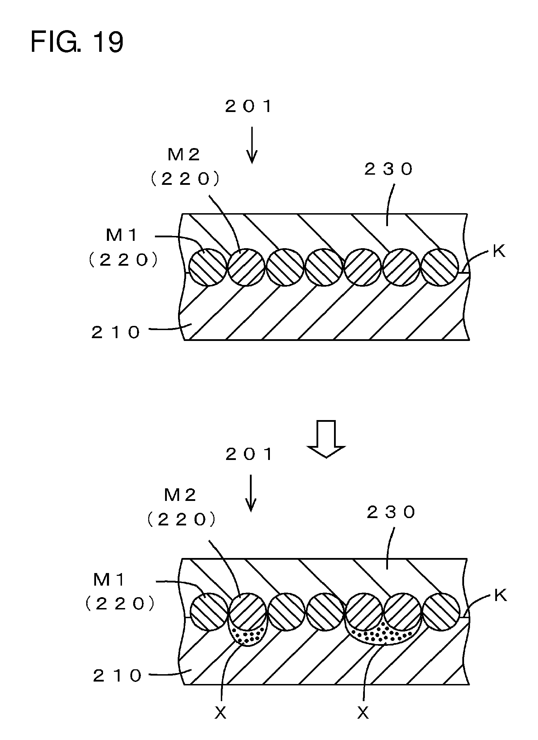

Next, a modification of the substrate for a printed wiring board according to the third embodiment will be described with reference to Fig. 19.
In this modification, the metal particles forming the conductive ink layer are changed. Other configurations are the same as those in the above-described third embodiment. The same components as those in the above third embodiment, and components having the same functions as those in the third embodiment are assigned the same reference numerals, and a description of those components is omitted.

In this modification, the conductive ink layer 220 is formed of two types of metal particles, namely, metal particles M1 composed of nickel (Ni) and metal particles M2 composed of copper (Cu).
With this configuration, it is easy to adjust the number of metal particles M1 per unit area, the metal particles M1 being composed of nickel (Ni) and dispersed and made to adhere to an interface K between an insulating base 210 and a plating layer 230, and the metal particles M1 can be dispersed and made to adhere more uniformly.
In the case where a substrate 201 for a printed wiring board having this configuration is placed in an oxidizing atmosphere at a high temperature, as shown in the lower portion of Fig. 19, a copper oxide layer X is grown only on areas of the interface K where the metal particles M2 composed of copper (Cu) are present. That is, it is possible to prevent the copper oxide layer X from growing in the form of a uniform layer at the interface K. Consequently, this non-uniform copper oxide layer X provides an anchoring effect to prevent a decrease in the adhesive force between the insulating base 210 and the plating layer 230.
Thus, it is possible to effectively prevent separation of the insulating base 210 and the plating layer 230 caused by the growth of an oxide in an oxidizing atmosphere at a high temperature. Accordingly, a highly reliable substrate 201 for a printed wiring board can be provided.

Furthermore, the nickel (Ni) particles and the copper (Cu) particles used as the metal particles are present at the interface K in the form of particles. Accordingly, for example, when a printed wiring board is formed using the substrate 201 for a printed wiring board, in the etching step B5-1, the metal particles M1 composed of nickel (Ni) can also be etched together with the etching of the metal particles M2 composed of copper (Cu). Consequently, a more satisfactory etching property can be realized.
A mixing ratio of nickel (Ni) and copper (Cu) in the conductive ink layer 20, the mixing ratio being determined by Ni/(Ni + Cu), is preferably 0.05 to 0.9, and more preferably 0.2 to 0.8.

### EXAMPLE 5

A conductive ink in which nickel particles having a particle diameter of 40 nm were dispersed in water as a solvent and which had a nickel concentration of 5% by weight was prepared. This conductive ink was applied onto a surface of a polyimide film (Kapton EN), which is an insulating base, and dried at 60°C for 10 minutes in air. Heat treatment was further performed at 300°C for 30 minutes in a nitrogen atmosphere (oxygen concentration: 100 ppm). Electroless copper plating was further performed on the surface of the resulting conductive ink layer to form a copper layer having a thickness of 0.3 µm, and copper electroplating was further performed on the copper layer. Thus, a substrate for a printed wiring board, the substrate having a thickness of 12 µm, was obtained.

### EXAMPLE 6

The experiment was performed as in Example 5 except that the atmosphere of the heat treatment was changed to an atmosphere containing 3% of hydrogen and 97% of nitrogen. Electroless copper plating was further performed on the conductive ink layer to form a copper layer having a thickness of 0.3 µm, and copper electroplating was further performed on the copper layer. Thus, a substrate for a printed wiring board, the substrate having a copper thickness of 12 µm, was obtained.

### EXAMPLE 7

A peel strength test and an etching property test were performed by using the following samples and test methods. The peel strength and the etching property were evaluated by criteria described below. The results are shown in Table.

### (Samples)

The following three types of samples including a plating layer (composed of copper) having the same thickness and the same shape were used.
Thickness of plating layer: 18 µm
Shape: Strip shape having a width of 1 cm
Sample 1: A substrate for a printed wiring board according to (the third embodiment of) the present invention.
Sample 2: A substrate for a printed wiring board, the substrate having a copper layer formed by a sputtering method but not having seed layer.
Sample 3: A substrate for a printed wiring board, the substrate having seed layers (Ni and Cr) formed by a sputtering method.

### (Evaluation of peel strength)

### Test method

Each of the samples was left to stand in air at 150°C for 168 hours, and the polyimide film surface of the sample was then bonded to a rigid plate with a double-sided adhesive. Next, a cutter knife or the like was inserted between the conductive layer and the polyimide. The conductive layer was subjected to 180-degree peeling at a tensile speed of 50 mm/min, thus measuring the peel strength (adhesion strength).
In the case where the peel strength was 6 N/cm or more, the sample was evaluated as "O". In the case where the peel strength was less than 6 N/cm, the sample was evaluated as "×".

### (Evaluation of etching property)

Each of the samples was immersed in a 10% aqueous sodium persulfate solution at 40°C for 120 seconds, and the presence or absence of residue was observed with a metallurgical microscope.
In the case where the residue did not remain, the sample was evaluated as "O". In the case where the residue remained, the sample was evaluated as "×".

**[Table]**

| | Peel strength | | Evaluation of etching property |
|---|---|---|---|
| | Initial | After 168 hours at 150°C | |
| Sample 1: Present invention (Third embodiment) | 9N/cm | O: 8N/cm | O |
| Sample 2: No seed layer | 8N/cm | ×: 1N/cm | O |
| Sample 3: Having seed layer | 8N/cm | O; 7N/cm | × |

Referring to the results shown in Table, in the substrate for a printed wiring board according to the third embodiment of the present invention, it is possible to realize both the prevention of separation of the conductive layer in an oxidizing atmosphere at a high temperature and a satisfactory etching property.

### Industrial Applicability

According to the present invention, a high-density, high-performance substrate for a printed wiring board, and a high-density, high-performance printed wiring board can be satisfactorily provided at a low cost without requiring vacuum equipment. Thus, the present invention has a high industrial applicability in the field of printed wiring boards. Reference Signs List

- 1: substrate for printed wiring board
- 11: insulating base
- 12: first conductive layer
- 12a: electroless metal plating portion
- 13: second conductive layer
- 2: printed wiring board
- 2a: resist
- 2b: wiring pattern
- 3: printed wiring board
- 3a: resist
- 3b: wiring pattern
- 31: insulating base
- 32: first conductive layer
- 32a: electroless metal plating portion
- 33: second conductive layer
- 4: printed wiring board
- 4a: resist
- 4b: wiring pattern
- 41: printed wiring layer
- 41a: insulating base
- 41b: conductive layer
- 42: first conductive layer
- 42a: electroless metal plating portion
- 43: second conductive layer
- M: metal particle
- V: void
- 101: substrate for printed wiring board
- 102: substrate for printed wiring board
- 103: printed wiring board
- 104: copper-clad laminated substrate
- 105: double-sided printed wiring board
- 110: base
- 111: through-hole
- 120: conductive ink layer
- 130: plating layer
- 140: resist
- 141: pattern mask
- 142: resist pattern
- 150: conductive layer
- A1: through-hole-forming step
- A2: conductive ink-applying step
- A3: plating step
- A4: resist pattern-forming step
- A5: wiring circuit-forming step
- A5-1: etching step
- A5-2: resist pattern-removing step
- 201: substrate for printed wiring board
- 202: substrate for printed wiring board
- 203: printed wiring board
- 210: base
- 220: conductive ink layer
- 230: plating layer
- 240: resist
- 241: pattern mask
- 242: resist pattern
- B 1: pretreatment step
- B2: conductive ink-applying step
- B3: plating step
- B4: resist pattern-forming step
- B5: wiring circuit-forming step
- B5-1: etching step
- BS-2: resist pattern-removing step
- K: interface
- M1: metal particle
- M2: metal particle
- N: seed layer
- X: copper oxide
The invention will now be described with reference to the following numbered clauses:

### [Clause 1]

A substrate for a printed wiring board, comprising an insulating base; a first conductive layer stacked on the insulating base; and a second conductive layer stacked on the first conductive layer, wherein the first conductive layer is a coating layer composed of a conductive ink containing metal particles, and the second conductive layer is a plating layer.

### [Clause 2]

The substrate for a printed wiring board according to Clause 1, wherein a void portion of the first conductive layer formed of the coating layer composed of the conductive ink is filled with an electroless metal plating portion.

### [Clause 3]

The substrate for a printed wiring board according to Clause 1 or 2, wherein the first conductive layer is a coating layer composed of a conductive ink containing metal particles having a particle diameter of 1 to 500 nm.

### [Clause 4]

The substrate for a printed wiring board according to any one of Clauses 1 to 3, wherein the metal particles are particles obtained by a liquid-phase reduction method in which metal ions are reduced by an action of a reducing agent in an aqueous solution containing a complexing agent and a dispersant.

### [Clause 5]

The substrate for a printed wiring board according to any one of Clauses 1 to 4, wherein the metal particles are particles obtained by a titanium redox method.

### [Clause 6]

The substrate for a printed wiring board according to any one of Clauses 1 to 5, wherein an interlayer composed of at least one element selected from Ni, Cr, Ti, and Si is present between the insulating base and the first conductive layer.

### [Clause 7]

A printed wiring board produced by using the substrate for a printed wiring board according to any one of Clauses 1 to 6.

### [Clause 8]

The printed wiring board according to Clause 7, wherein the printed wiring board is a multilayer board including an insulating base and conductive layers facing each other with the insulating base therebetween, at least one of the conductive layers includes a first conductive layer and a second conductive layer, the first conductive layer is a coating layer composed of a conductive ink, and the second conductive layer is a plating layer provided on the first conductive layer.

### [Clause 9]

The printed wiring board according to Clause 7 or 8, wherein the second conductive layer is formed as a pattern on the first conductive layer functioning as an underlayer by a semi-additive process using a resist.

### [Clause 10]

A method for producing a substrate for a printed wiring board comprising a step of forming a first conductive layer by applying, onto an insulating base formed of a film or a sheet, a conductive ink in which metal particles having a particle diameter of 1 to 500 nm are dispersed, and performing heat treatment, whereby the metal particles in the applied conductive ink are fixed as a metal layer onto the insulating base; and a step of forming a second conductive layer by stacking a metal layer on the first conductive layer by plating.

### [Clause 11]

The method for producing a substrate for a printed wiring board according to Clause 10, further comprising a step of electroless metal plating for filling a void portion of the first conductive layer, the step of electroless metal plating being performed before the step of forming the second conductive layer.

### [Clause 12]

The method for producing a substrate for a printed wiring board according to Clause 10 or 11, wherein the metal particles are particles obtained by a liquid-phase reduction method in which metal ions are reduced by an action of a reducing agent in an aqueous solution containing a complexing agent and a dispersant.

### [Clause 13]

The method for producing a substrate for a printed wiring board according to any one of Clauses 10 to 12, wherein the metal particles are particles obtained by a titanium redox method.

### [Clause 14]

The method for producing a substrate for a printed wiring board according to any one of Clauses 10 to 13, wherein the heat treatment of the conductive ink is performed at a temperature of 150°C to 500°C in a non-oxidizing atmosphere or a reducing atmosphere.

## Claims

1. l A substrate for a printed wiring board, comprising an insulating base and a conductive layer covering a surface of the base, wherein the base has a through-hole penetrating the base, and the conductive layer is composed of a conductive ink layer that covers the entire inner surface of the through-hole and an upper surface and a lower surface of the base and that contains metal particles.

2. The substrate for a printed wiring board according to Claim 1, wherein the conductive layer includes a first conductive layer composed of a conductive ink layer that covers the entire inner surface of the through-hole and the upper surface and the lower surface of the base and that contains metal particles, and a second conductive layer composed of a plating layer stacked on the first conductive layer.

3. The substrate for a printed wiring board according to Claim 2, wherein the plating layer is formed by electroless plating and/or electrolytic plating.

4. The substrate for a printed wiring board according to any one of Claims 1 to 3, wherein the conductive ink layer is composed of a conductive ink containing metal particles having a particle diameter of 1 to 500 nm.

5. The substrate for a printed wiring board according to any one of Claims 1 to 4,
wherein the metal particles are particles obtained by a liquid-phase reduction method in which metal ions are reduced by an action of a reducing agent in an aqueous solution containing a complexing agent and a dispersant.

6. The substrate for a printed wiring board according to any one of Claims 1 to 5, wherein the metal particles are particles obtained by a titanium redox method.

7. The substrate for a printed wiring board according to any one of Claims 1 to 6, wherein an interlayer composed of at least one element selected from Ni, Cr, Ti, and Si is present between the insulating base and the first conductive layer.

8. A printed wiring board produced by using the substrate for a printed wiring board according to any one of Claims 1 to 7.

9. The printed wiring board according to Claim 8, wherein the second conductive layer is formed as a pattern on the first conductive layer functioning as an underlayer by a semi-additive process using a resist.

10. A method for producing a printed wiring board comprising at least a through-hole-forming step of forming a through-hole in an insulating base; a conductive ink-applying step of applying a conductive ink containing metal particles dispersed in a solvent onto the insulating base having the through-hole, the conductive ink-applying step being performed after the through-hole-forming step; and a heat-treatment step of performing heat treatment after the conductive ink-applying step.

11. The method for producing a printed wiring board according to Claim 10, further comprising at least an electrolytic plating step of performing electrolytic copper plating after the heat-treatment step; a resist pattern-forming step of forming a resist pattern after the electrolytic plating step; and an etching step of performing etching after the resist pattern-forming step.

12. The method for producing a substrate for a printed wiring board according to Claim 21, further comprising an electroless plating step of performing electroless plating before the electrolytic plating step.

13. A method for producing a printed wiring board comprising at least a through-hole-forming step of forming a through-hole in an insulating base; a conductive ink-applying step of applying a conductive ink containing metal particles dispersed in a solvent onto the insulating base having the through-hole, the conductive ink-applying step being performed after the through-hole-forming step; a heat-treatment step of performing heat treatment after the conductive ink-applying step; a resist pattern-forming step of forming a resist pattern after the heat-treatment step; an electrolytic plating step of performing electrolytic copper plating after the resist pattern-forming step; a resist pattern-removing step of removing the resist pattern formed in the resist pattern-forming step, the resist pattern-removing step being performed after the electrolytic plating step; and a conductive ink layer-removing step of removing a conductive ink layer exposed in the resist pattern-removing step, the conductive ink layer-removing step being performed after the resist pattern-removing step.

14. The method for producing a printed wiring board according to Claim 13, further comprising an electroless plating step of performing electroless plating before the resist pattern-forming step.

15. A substrate for a printed wiring board comprising an insulating base and copper stacked on a surface of the insulating base, wherein metal particles that suppress oxidation of a copper layer are dispersed and made to adhere to an interface between the insulating base and the copper.

16. The substrate for a printed wiring board according to Claim 15, wherein the metal particles include at least Ni particles.

17. The substrate for a printed wiring board according to Claim 15, wherein the metal particles include Ni particles and Cu particles.

18. A method for producing a substrate for a printed wiring board comprising at least a conductive ink-applying step of applying a conductive ink containing metal particles onto a surface of an insulating base; a heat-treatment step of performing heat treatment after the conductive ink-applying step; and an electrolytic plating step of performing electrolytic copper plating after the heat-treatment step.
